Europäisches Patentamt

European Patent Office

Office européen des brevets

(11) Publication number: **0 224 753 B1**

# EUROPEAN PATENT SPECIFICATION

(45) Date of publication of patent specification: **26.01.94**   (51) Int. Cl.5: **H03M 7/42**, H03M 7/40

(21) Application number: **86115453.2**

(22) Date of filing: **07.11.86**

(54) **Probability adaptation for arithmetic coders.**

(30) Priority: **04.12.85 US 805163**

(43) Date of publication of application:
**10.06.87 Bulletin  87/24**

(45) Publication of the grant of the patent:
**26.01.94 Bulletin  94/04**

(84) Designated Contracting States:
**DE FR GB IT**

(56) References cited:
**EP-A- 0 154 860**
**US-A- 3 237 170**

**IEEE TRANSACTIONS ON COMMUNICA-
TIONS, vol. COM-29, no. 6, June 1981, pages
858-867, IEEE, New York, US; G.G. LANGON,
Jr et al.: "Compression of black-white im-
ages with arithmetic coding"**

**IEEE TRANSACTIONS ON INFORMATIONS
THEORY, vol. IT-24, no. 6, November 1978,
pages 668-674, IEEE, New York, US; R.G. GAL-
LAGER: "Variations on a theme by Huffman"**

(73) Proprietor: **International Business Machines
Corporation
Old Orchard Road
Armonk, N.Y. 10504(US)**

(72) Inventor: **Pennebaker, William Boone
R.D. 12, Crane Road
Carmel New York 10512(US)**
Inventor: **Mitchell, Joan Laverne
Seven Cherry Hill Circle
Ossining, New York 10562(US)**

(74) Representative: **Mönig, Anton, Dipl.-Ing. et al
IBM Deutschland Informationssysteme
GmbH,
Patentwesen und Urheberrecht
D-70548 Stuttgart (DE)**

**Description**

FIELD OF THE INVENTION

The present invention relates to a computer-implemented method of adapting the probability of the occurrence of a first of two binary symbols in response to the actual occurrence of a series of binary events in a binary arithmetic coding system utilizing selected confidence limits for the probability.

BACKGROUND OF THE INVENTION

Various phenomena are represented as binary decisions in which one of two decision symbols (such as yes and no) is characterized by one probability (Pr) and the other symbol is characterized by a probability (1-Pr). The less likely symbol is typically referred to as the less (or least) probable symbol LPS whereas the other symbol is referred to as the more (or most) probable symbol MPS.

Generally, the probability Pr is initially determined as an estimate from previous data or an initial estimate based on intuition, mathematics, assumptions, statistics collection, or the like. This estimate may be correct at some times or under some conditions but may not reflect the true probabilities at other times or under other conditions.

In some prior technology, the probabilities are determined before data processing --such as data encoding-- and remain fixed. In such prior art, results obtained may be inaccurate because they are not based on current actual data.

In other prior technology, probabilities are evaluated which are intended to reflect data history. One article which discusses such prior art is included in the IBM Technical Disclosure Bulletin in volume 22, No. 7, December 1979, pps. 2880-2882, and is entitled "Method for Coding Counts to Coding Parameters" (by G.G. Langdon, Jr. and J.J. Rissanen). The article states that it is desired to detect changes in the symbol probabilities from observed symbol occurrences, and modify the LPS probability q accordingly. One approach suggested by the article is to change q to reflect the number of counts of one symbol divided by the total number of symbols counted during a symbol string. That is, if k is the counts for one symbol and n is the number of counts for both symbols, symbol probability is changed based on k/n.

Another article by Langdon and Rissanen, "Compression of Black/White Images with Arithmetic Coding", IEEE Transactions on Communications, volume COM-29, No. 6, June 1981, describes black and white image compression techniques which utilize the probability of the occurrence of consecutive ones or zeros. In paragraphs D. and E. on page 865 this article discusses the probability p of a series of consecutive zeros and ones. In paragraph E. is also explained, that this probability might be adapted if probability p for a certain event becomes smaller than 0.2 in which case p ought to be increased. In the last sentence of paragraph E. are mentioned suitable lower and upper bounds but it is not explained whether or how the skew value Q is updated when the upper bound is reached.

The article "Variations on a Theme by Huffman" by Robert G. Gallager in IEEE Transactions on Information Theory, Vol. IT-24, No. 6, November 1978 pages 668-674 also describes adaptive codes. Here, however, each letter of an alphabet is separately counted and incremented each time this letter occurs. Periodically after each Nth letter in the source sequence each of the letter counts is multiplied by a fixed number < 1, e.g. 1/2. It is said that this method is yielding better estimates for slowly varying statistics.

US Patent US-A-3 237 170 relates to data compression of a sequence of data. The circuitry utilizes an updating predictor which accepts each N-bit sequence and the preceding M-bit sequence applied after a delay. The predictor is a random access storage device which stores the most likely N-bit combination to follow each M-bit combination. This circuitry comprises a table of different binary words. These tables are updated any time an averager circuit reaches a predetermined threshold.

Other prior technology includes U.S. Patents US-A-4467317, US-A-4286256, and US-A-4325085 and an IBM Technical Disclosure Bulletin article in volume 23, No. 11, April 1981, pps 5112-5114, entitled "Arithmetic Compression Code Control Parameters Approximation" (By. D.R. Helman, G.G. Langdon, Jr., and J.J. Rissanen). The cited references are incorporated herein by reference to provide background information.

Field of the Invention

Methods and embodiments according to the invention are defined in claims 1 to 12, and 13-17, respectively.

The present invention addresses the problem of providing a computationally simple yet nearly optimum technique for adaptively determining symbol probabilities in a binary decision context. This object is achieved by a method and apparatus for revising the LPS probability (and, hence, the MPS probability) based on confidence limits. Specifically, the present invention includes estimating the LPS probability q and revising the value of q to a value qnew which is just sufficient to bring the LPS probability into known confidence limits after confidence has been lost.

The present invention provides that the number of LPS symbols be counted (as k) and that the number of total symbols (including LPS and MPS symbols) be counted as n. An initial estimate for the value of q is initially set. Based on the estimated value of q, the value of n, a selected confidence level C, and an upper bound (ub) and a lower bound ($\ell$b) for k is evaluated. If the actual k is beyond the evaluated bounds, q is assigned a revised value qnew which is the minimal adjustment that places k back within the bounds.

Limiting the change of q to just enter k within the bounds set therefor is of great significance. If qnew were adjusted to simply track k/n, the response time to correct for temporarily eccentric data would be inordinately long. That is, data processing (e.g., data encoding) could proceed for a long period with grossly inaccurate probabilities. The present invention achieves the object of adjusting the q value enough to respond to actual counts, but not enough to deleteriously affect computation time as the result of statistical fluctuations.

In this regard, the present invention is of particular value when processing data with a relatively small number of input samples, especially when q has a value near 0.5. Under such conditions, the confidence approach of the present invention significantly outperforms a technique wherein q tracks k/n.

Preferably, the present invention provides a table which includes a plurality of allowed q value entries selected from all possible entries and ordered by magnitude. In its preferred form, the table has m n-bit entries where $m<2^n$. Entries are selected such that each has a minimum coding inefficiency for at least one actual probability relative to all other possible estimated probabilities. Entries selected in this way are substantially uniformly spaced (along a logarithmic scale). The smaller table size achieves the object of enhanced computational speeds and a reduction in storage requirements.

Moreover, the invention provides for probability adjustments that include approximations that limit the number of permitted next entries from a subject entry. By reducing the number of next entries, the changes in probability can be implemented in a deterministic finite state machine. When confidence is lost, the q value is shifted to a prescribed entry in the table at which confidence is restored. In that way, the minimal adjustment to q is effectuated to restore confidence. In a preferred mode, based on the measure of lost confidence, a shift of one or more entries may be effectuated at one time.

In accordance with the invention, the bounds for k --namely kmin and kmax-- remain constant after they are first evaluated. Thereafter, the level of confidence is permitted to vary in a known manner to derive updated values for q based on incoming data. This achieves the object of facilitated computations where the bounds remain fixed over time and k need not be measured against sliding boundaries.

The present invention thus permits the LPS (and, hence, the MPS) probability to be adapted as new data is entered. In this regard, the invention permits probability adjustment during a coding process, such as arithmetic coding.

Moreover, in a specific embodiment, the present probability adaptation is applied to an arithmetic coding system in which range is represented and computed in the logarithmic domain --as is set forth in a co-pending European application EP-A-0 225 488 filed on even date herewith, entitled "Log Encoder/Decoder System", and invented by J.L. Mitchell, W.B. Pennebaker, and G. Goertzel (all employees of the IBM Corporation).

BRIEF DESCRIPTION OF THE DRAWINGS

Fig.1 is a flowchart illustrating the invention in general.
Fig.2 is an illustration showing probabilities used in probability adaptation according to the present invention.
Fig.3 is a graph showing curves kmin and kmax, on either side of kavg, which indicate the bounds at which confidence is lost under specific conditions.
Fig.4 is an illustration depicting the changing of q to restore confidence.
Fig.5 is a flowchart for a specific binary arithmetic coder embodiment of the invention.
Fig.6 through Fig.12 are flowcharts detailing the operations set forth in Fig.5.
Fig.13 is a state diagram of a deterministic finite state machine illustrating the probability adjustment process of the invention where various magnitudes of adjustment are provided.

Fig.14 is an illustration of a plurality of curves showing coding inefficiency relative to the entropy limit for all possible LP values for a sample probability interval.

Fig.15 is an illustration showing the selection of allowed probability values from among the possible probability values based on a given inefficiency coding limit.

DESCRIPTION OF THE INVENTION

1. General Description of Invention

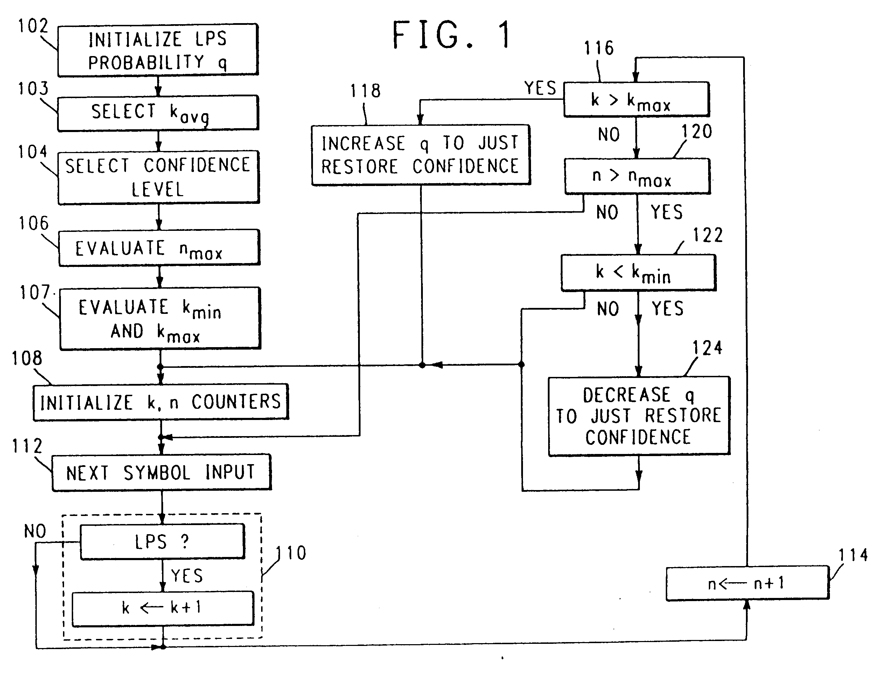

Referring to Fig.1, a general flowchart shows the steps in adapting a probability q based on the actual symbols of binary decisions. Each decision, it is noted, has two possible outcomes or answers (hereafter referred to as "symbols"). One symbol may represent "0" and the other "1"; or one symbol may represent "black" and the other "white"; or one symbol may represent "yes" and the other "no" depending on context. The more probable symbol at a particular time is referred to as the MPS and the less probable symbol is referred to as the LPS. The LPS symbol probability is identified as q and the MPS symbol probability is identified as p. Accordingly, q is always less than or equal to 0.5.

Such binary decisions are well-known, for example, the occurrence of a white or black symbol for a picture element (pel) in a facsimile system. The probability of a pel being black in a predominantly black background would be expected to be greater than for the pel being white. In this case, the probability of the pel being white is q. Over time or from one background to another, the respective probabilities for the white symbol and black symbol may vary. In this regard, as the background changes from black to white, the probability of a pel being white may switch from being the LPS to the MPS. In accordance with the invention, variations in probability and the switching between LPS and MPS conditions are accounted for.

As seen in Fig.1, there is an initial estimate for q (and hence for p which is simply 1-q). If there is no information about the picture background, q and p might be set at 0.5. Generally, however, there is some information suggesting that the probability of q be some lesser value. The initial value for q is entered in step 102.

In step 103, a value for kavg is selected. kavg is selected to represent an expected LPS count and is typically based on historical data or other relevant information. The value selected is somewhat arbitrary, although the value eight (8) has provided notably good results.

In step 104, a confidence level C is selected. Confidence level is a well-known concept in probability theory. Basically, the confidence level is used in answering the question of how much confidence there is that a given statement is true. In the present invention, the use of a confidence level extends beyond the conventional inquiry of how much confidence there is in a statement. The concept of confidence is further employed as a factor in determining how much q should be adjusted when confidence is lost. Confidence is normally measured as a percent or probability and herein may be selected with considerable latitude. In step 104, it may be determined that there should be 60% confidence between q and the actual counts that represent an estimate of q.

Once an initial value for q is set and kavg selected, nmax is evaluated in step 106. nmax corresponds to a maximum number of total symbols that are to be examined as a block of data. This number may be arbitrarily selected but is preferably based on the variable kavg. The value nmax is preferably defined as:

$$nmax = kavg/q \qquad (1)$$

Related to the confidence level set forth in step 104 are two bounds kmin and kmax which are evaluated in step 107. Corresponding to each bound is a confidence bound level lb and ub, respectively, which indicate the likelihood of a k count falling on or outside the kmin or kmax bound. There are several methods for determining these bounds.

One technique for evaluating the lower bound kmin and the upper bound kmax relies on the Bernoulli Theorem which is expressed hereinbelow:

$$P(|k/n|-q|<e) > 1-C = 1-(pq/n e^2) \qquad (2)$$

where

P     is the probability that the estimate k/n is within e of the true probability q
p     is the MPS probability
q     is the LPS probability
k     is the LPS count

4

n is the total symbol count

k/n is the relative frequency --an estimate of q

e is a bound on the magnitude, |(k/n)-q|

Solving for the LPS count, k, Equation (2) yields:

$$kmax < nq + (nqp/C)^{.5} \qquad (3)$$

$$kmin > nq - (nqp/C)^{.5} \qquad (4)$$

The bounds as set forth in Equations (3) and (4) are subject to approximations which attend the Bernoulli Theorem. Hence, although they provide some indication of what the bounds may be, a more exact and preferred approach is set forth hereinbelow based on the binomial coefficient expression:

$$P_{k,n} = (n!/k! \, (n-k)!) \, p^k \, q^{n-k} \qquad (5)$$

From the binomial coefficient expression, a probability $P_{k,n}$

for each k,n

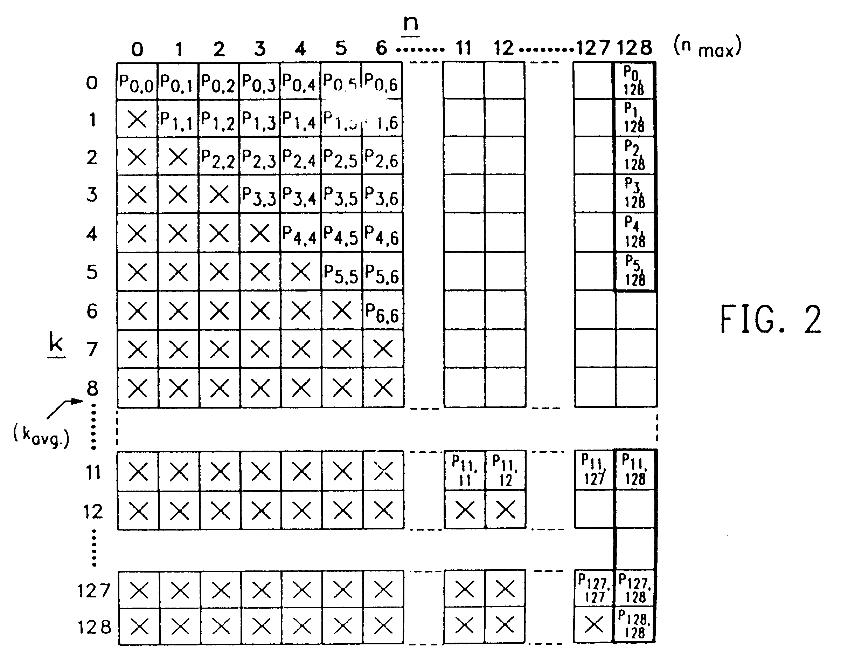

pair is readily computed for q. Conceptually, this may be viewed as a table as in Fig.2. For each table entry, there is a probability

corresponding to k LPS symbols occurring out of n total symbols. To determine kmin, a lower confidence bound level $\ell b$ is set which represents

the total probability of k being less than or equal to kmin. For example, the lower confidence bound is selected so that the probability of k being less than or equal to kmin is approximately .18. kmin is that k value at which the sum of probabilities for all entries wherein n = nmax and k≤kmin is less than or equal to .18.

Mathematically, this relationship is expressed as:

$$\sum_{k=0}^{kmin} P_{k,nmax} \leq .18 \qquad (6)$$

In the table of Fig.2, the probabilities that are totalled for kmin = 5 are shown with a bold outline in the upper right portion of the table.

In finding kmin, probability sums for each k --starting at k = 0-- are totalled along the n = nmax column until a k is reached at which the confidence level (e.g. .18) is exceeded. The highest value for k at which the confidence level is not yet reached is set as kmin. (In practice, the kmin value may be selected to only slightly exceed confidence.) In Fig.2, the kmin value occurs at k = 5.

To evaluate kmax, a computation is performed based on an upper confidence bound. Again a confidence bound level of approximately .18 is considered, by way of example, for the upper bound. For this computation a kmax is sought wherein the probabilities for all entries along the column n = nmax are summed for all k's where kmax≤k≤nmax. By starting at k = nmax, probability sums of successively decreasing k values may be taken until a sum is detected which is greater than .18. The lowest k value at which confidence is not yet reached (i.e., where the sum of probabilities is less than .18) is evaluated as kmax at step 108. For kmax = 11 and nmax = 128, the addend probabilities are shown in the bold outline in the lower right of the table in Fig.2. Due to the symmetry of the probability distribution, it is observed that kmin is equal or approximately equal to (kavg - Δ) and that kmax is equal or approximately equal to (kavg + Δ). Accordingly, kmax may be readily derived once kmin has been determined.

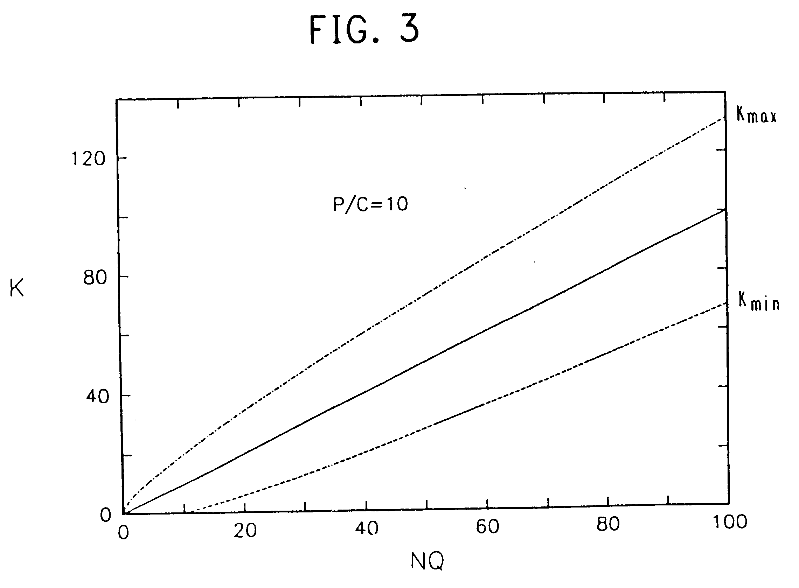

The values of kmin and kmax are plotted in the graph of Fig.3 which shows k versus nq. It is noted that the upper bound and lower bound are shown in dashed line representation and correspond to the respective Equations (3) and (4). Referring again to the Bernoulli Theorem, when k and n are small, the true probability that k will exceed a given bound is substantially less than Equation (3) indicates.

In step 108, a k counter and an n counter are initialized to zero. The k and n counts are discussed in greater detail hereinbelow. When initialized to zero, the counters are incremented as appropriate. (As an alternative, the k counter may be set to kmax and the n counter set to nmax. In this alternative approach, each count is respectively decremented until zero is reached. In either case, k and n counts are maintained.)

Given the estimated q, nmax, kmin, and kmax, and initialized counts for k and n, the process of adapting the value of q (and hence p) to better conform to actual symbol data proceeds as follows. At step 112, a next symbol input is entered. With each symbol input, the n count is incremented (if initialized to zero) at step 114. For each symbol input which corresponds to an LPS, the k count is incremented (if initialized at zero) at step 110.

Also, with each symbol input, a comparison is made between k and kmax at step 116. If k is equal to or exceeds kmax, confidence has been lost and q must be adjusted. That is, q is increased in step 118 to a new value (qnew) in order to account for the excessive counts k. With the higher q, the probabilities at the higher end of the table of Fig.2 increase. In its preferred mode, the present invention provides that --with the new higher q-- the values for kmin and kmax remain the same which results in an unchanging value for kavg. Accordingly, based on Equation (1), the value for nmax is reduced.

The adjusting of q to just restore confidence is observed with reference to Tables I and II set forth hereinbelow. Tables I and II are based on Equation (5) which provides for exact calculation of the probability that q is within confidence bounds. In particular, Tables I and II were generated numerically using Equation (5) for values of kavg and a confidence level which simulations have shown give good coding of both fixed and variable statistics files.

Table I.   For q=0.0625, kavg=8

confidence level=0.182426 for kmin=5, nmax=128

| k | qnew | $\log_2(q/qnew)$ |
|---|---|---|
| 5. | 0.0625 | 0 |
| 4. | 0.0533 | 0.23 |
| 3. | 0.0439 | 0.51 |
| 2. | 0.0342 | 0.87 |
| 1. | 0.0242 | 1.37 |
| 0. | 0.0133 | 2.24 |

confidence level=0.177606 for kmax=11, nmax=128

| n | qnew | $\log_2(qnew/q)$ | $\log_2(nmax/n)$ |
|---|---|---|---|
| 11. | 0.854 | 4.78 | 3.54 |
| 32. | 0.257 | 2.04 | 2.00 |
| 64. | 0.126 | 1.01 | 1.00 |
| 96. | 0.084 | 0.42 | 0.41 |
| 128. | 0.062 | 0.00 | 0.00 |

Table II.    For q=0.5, kavg=8

confidence level=0.105057 for kmin=5, nmax=16

| k | qnew | log2(q/qnew) |
|---|---|---|
| 5. | 0.500 | 0.00 |
| 4. | 0.436 | 0.20 |
| 3. | 0.368 | 0.44 |
| 2. | 0.297 | 0.75 |
| 1. | 0.219 | 1.19 |
| 0. | 0.131 | 1.93 |

confidence level=0.105057 for kmax=11, nmax=16

| n | qnew | log2(qnew/q) | log2(nmax/n) |
|---|---|---|---|
| 11. | 0.815 | 1.43 | 0.54 |
| 12. | 0.716 | 0.81 | 0.41 |
| 16. | 0.500 | 0.00 | 0.00 |

Each of the values of qnew listed in the Tables I and II is the value required to just return to the confidence range, given the value of k and n at which the confidence limit was exceeded.

In the lower portion of Table I, it is observed that if the probability q is to be raised from .0625 to .854 while maintaining approximately 18% confidence at the upper bound, the maximum n value drops from 128 to 11. It is similarly observed that, if q remains unchanged as a result of data inputs, confidence is maintained with the original nmax value of 128.

In Table II, as in Table I, the upper portion shows the qnew required when k falls below kmin (after nmax total counts) with each respective value 0, 1, 2, 3, 4, or 5. If, after nmax counts, k equals four, q is adjusted to be .436 from its initial value of 0.5. Moreover, in the lower portion which relates to k equalling or exceeding kmax, update values for the maximum n are noted for new increased q values.

In comparing the two Tables I and II, it is noted that both have the same kmin and kmax values but that, for Table I, q is much smaller than for Table II. The probability of each bound being met or exceeded in Table II is much less than for Table I --about 10% as compared to about 18%.

In examining the tables, it is observed that the upper bound of Table I has the same confidence level as the lower bound of Table I. Similarly, the upper bound and the lower bound of Table II have the same level of confidence. This symmetry is not required. If desired, the confidence at the upper bound may be set at one level and the lower bound may be set at another level.

Similarly, the bounds kmin and kmax could be adjusted as a function of q to provide a more constant confidence level near $q=0.5$. Allowing the confidence limits to drop to 10% near $q=0.5$ does not strongly affect the estimate of q, in that statistical fluctuations are still sufficiently probable.

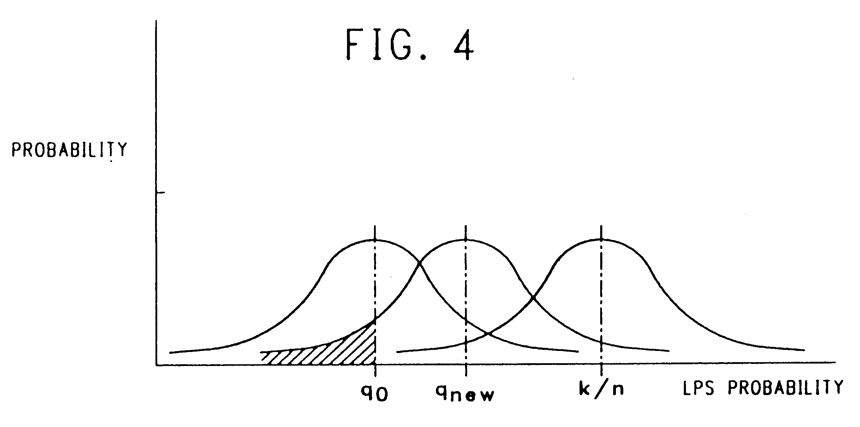

The significance of just restoring confidence is suggested in Fig.4. In Fig.4 the probability distribution for the LPS is shown initially centered on $q_0$. It is then supposed that the actual count ratio k/n for a given block of data is considerably larger than $q_0$. If $q_0$ is increased to k/n, it has been found that inordinate computational requirements may result due to statistical fluctuations. Should $q_0$ in fact be correct, the shifting of the probability curve back to $q_0$ requires an unacceptably long computation time when k/n is tracked.

The present invention provides that the probability curve be shifted to a qnew at which confidence is restored, but k/n need not be followed. If an excessive k is again detected, the curve shifts again in the same direction it has already been shifted. If $q_0$ is in fact correct, the earlier statistical fluctuation is readily accounted for with a relatively small shift of the probability curve back towards a center at $q_0$. In this regard,

it is observed that --for a 20% confidence level at the lower end-- the area to the left of $q_0$ is 20% of the area under the qnew curve.

According to the invention, the new q probability will not be subject to the type of drastic changes which can occur when k/n is tracked. The time during which a grossly inaccurate value for q is used is reduced.

If k does not equal or exceed kmax, a check is made to determine if n equals or exceeds nmax at step 120. If n does not equal or exceed nmax, the next symbol input is entered at step 112. If n does equal or exceed nmax, a determination is made at step 122 as to whether k is less than or equal to kmin. If k is not less than or equal to kmin, there is still confidence at the lower bound and q need not be adjusted.

If k≤kmin, q is decreased sufficiently in step 124 to just restore confidence. The effect of reducing q may be noted in Fig.2. If q is reduced, the probabilities at the higher k's decrease whereas the probabilities at the lower k values increase. As the probabilities $P_{0,128}$, $P_{1,128}$, $P_{2,128}$, $P_{3,128}$, $P_{4,128}$, and $P_{5,128}$ in the upper right portion of the table increase due to decreasing q, kmin no longer represents a satisfied bound if nmax and the confidence level remain unchanged. To keep the value of kmin constant, nmax is increased. In that way, the k value has more events in which to reach the kmin value.

By maintaining kmin and kmax constant, the k values can be measured against a known fixed value rather than a changing value --thereby facilitating computations.

Whenever q is adjusted, the k and n counts are initialized at step 105. New data is then entered and processed based on the adjusted values of q and nmax.

Tables I and II show the ratio of q/qnew or qnew/q in logarithmic form in base-2 (represented by "log2"). This data is used in the context of a logarithmic encoder/decoder in an arithmetic coding system as detailed hereinbelow. It is noted that generally the ratio qnew/q can be approximated by the value of nmax/n.

Only for qnew greater than 0.5 is the approximation poor. This is because log2(qnew/q) is calculated assuming the MPS and LPS symbols are interchanged at q = 0.5. The log2(qnew/q) is really two parts, log2-(.5/q) and log2(qnew/.5). However, the term qnew/0.5 must be reinterpreted because of the symbol interchange, and that reinterpretation is included in the log calculation.

As noted previously, the values of q may be obtained from any of various sources, such as defined tables which include only certain possible or optimum values for q. One technique for forming the q table is set forth hereinbelow.


## 2. Probability Adaptation in a Log Encoder in an Arithmetic Coding Environment

The present invention contemplates embodiments which work with data block sizes (nmax) which can be renormalized rather than simply zeroed at the end of each block (as is described in the above embodiment).

In the present invention, it is noted that values for various parameters are stored, in table form, as function "inittbl" set forth in Appendix I. In particular, values for (a) the log of the probability p (log p); (b) the log of the ratio of probabilities (log q/p); (c) the maximum total count for a particular log of p value (nmaxlp); (d) how the table pointer must be moved to point to a probability value that is half or nearly half the current value (halfi); and (e) how the table pointer must be moved to point to a probability value that is twice or nearly twice the current value (dbli).

In reviewing the table "inittbl", it is observed that each data row comprises ten bytes of data. To move the data pointer from one log p value to the next adjacent value (up or down), the data pointer must be shifted (horizontally) along the length of a data row, e.g. 10 bytes. How far up or down the data pointer is to move depends on how far the new q probability deviates from the previous q value. If k is substantially less than kmin, a halving of q is appropriate and the pointer will be shifted the corresponding number of rows to place the data pointer at the log p value which corresponds to a halving of q. If k reaches kmax at a relatively small value for n, doubling (or even quadrupling) q may be appropriate. If halving or doubling is to be performed, the values set forth in the halfi and dbli columns, respectively, indicate how many bytes the data pointer is to be shifted to effectuate the change. Alternatively, by storing table indices at halfi and dbli for the allowed probabilities, the change from one probability to another probability can be effected without the need for computation. It is observed, in this regard, that an approximation is made in determining qnew to restore confidence. Referring to Table I hereinabove, it is noted that if k = 4, when the count n reaches nmax, q should ideally be changed from .0625 to .0533. Similarly, if k = 2 when count n reaches nmax, q should ideally be changed from .0625 to .0342.

In the presently described embodiment, an approximation for these "ideal" changes is employed. The k value at which the log2 (q/qnew) equals or most closely approximates one is considered to be a threshold.

The occurrence of a k value at or below this threshold prompts movement of the data pointer to a new q value that is at least approximately half the current q value. In Table I, q = .0625 is changed to .0342 if $k \leq 2$ when n reaches nmax (given the other conditions of Table I). Moreover, if k is between greater than 2 while less than or equal to 5, q is changed to a value one table position away from .0625. Accordingly, the change is based on confidence but includes an approximation.

Similarly, if kmax is equalled or exceeded, the value of log2 (nmax/n) is noted. The value of n at which k equals or exceeds $k_{max}$ and at which log2 (nmax/n) is closest to one represents a first threshold $n_1$. The value of n at which log2 (nmax/n) is closest to two is a second threshold $n_2$. For all values of a greater than or equal to the first threshold (i.e., $n \geq n_1$), q is increased by moving the data pointer one position in the table. For all values of n, $n_1 > n \geq n_2$, the value of q is doubled. In Table I, $n_1 = 64$ and $n_2 = 32$. For all values of $n < n_2$, a quadrupling of q is performed.

An examination of Table I shows that log2 (nmax/n) closely approximates log2 (qnew/q) required to restore confidence, thereby justifying the use of log2 (nmax/n) in determining how much change in q should be made. These approximations achieve the results of directing q toward a new value based on confidence while the number of permitted changes in q is limited. As confidence in the current q becomes worse, q is changed by larger factors in step-wise fashion. By limiting the number of next q's which can be selected, the q changing can be practically implemented as a deterministic finite state machine.

It is noted that the probability adjustments are also approximate in that they depend on the coarseness of the table of allowed values.

The allowed values of the entries listed in the inittbl are determined according to a Log Coder which is described in the aforementioned co-pending patent application. The allowed values, it is noted, are those values which remain after a number of constraints are applied. One technique for defining the allowed values is set forth in the next section.

Flow charts relating to the probability adaptation aspect of the Log Coder are now discussed. Note that the oval headers state the function which follows in the flow chart.

By way of terminology, the probability p is also referred to as P and the probability q as Q hereinbelow. The parameter R relates to range in an arithmetic coding system. In this regard, it is recognized that arithmetic coding normally involves assigning a certain symbol string to a specific range along a number line having a prescribed start point along the line. In the Log Coder, the range R is defined in the logarithmic domain. log R is thus the logarithm of the current range R and LR represents the magnitude of the log of R scaled to finite precision by a constant. LP and LQ similarly represent the magnitude of the log of P and Q scaled to finite precision by the same constant.

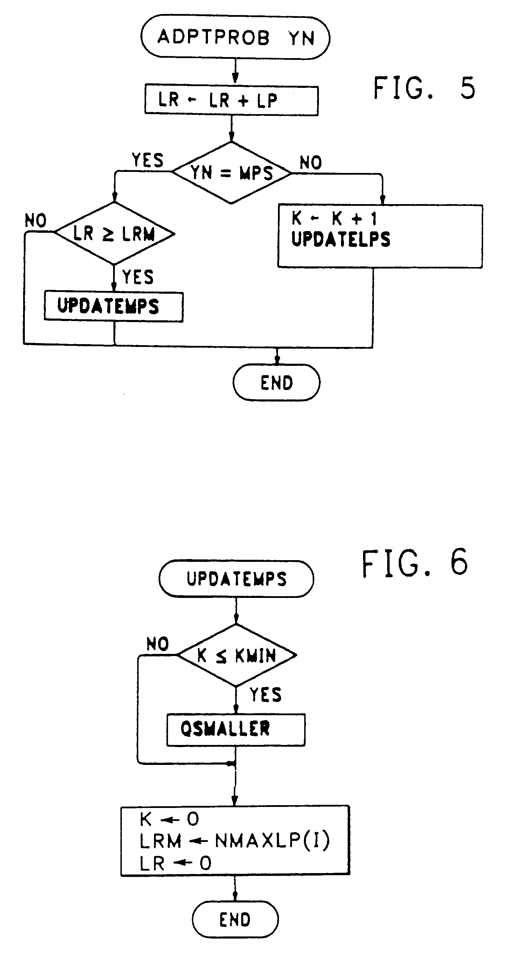

Referring to Fig.5, a probability estimator flow chart is shown. A scaled logarithmic representation of the range R is updated as LR←LR + LP. This first step corresponds to the range being updated in the logarithmic domain based on the value of the most probable symbol probability. In the general description of the invention, this step corresponds to n←n + 1. A decision is then made as to whether the current symbol is an MPS.

If it is, a decision is made as to whether LR is greater than or equal to a predefined maximum value thereof, LRM. If not, no further steps are taken. If so, the MPS is updated according to the flowchart in Fig.6. Note that LR refers to the same value as n which, in the software set forth in Appendix 1, is counted in units of LP. LRM contains NMAXLP(I) --nmax scaled by LP.

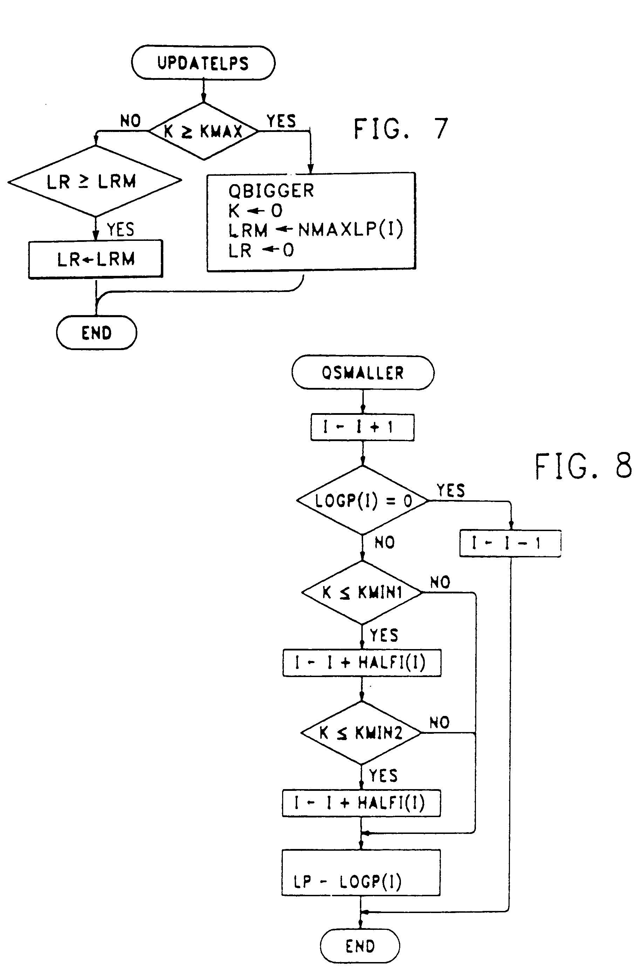

In Fig.6, UPDATEMPS first provides a test of k≤kmin. If not, k is initialized to zero, LR is initialized to zero, and LRM is set to a value NMAXLP(I). If k is less than or equal to kmin, the probability of q is first decreased according to the subroutine QSMALLER of Fig.8. That is, if the LPS count k is too small, the probability table pointer I is adjusted to a new position (smaller Q) which restores confidence in the probability estimate. Note that the last entry in the table of log P values is a zero. This is an illegal value which is used as a stop. If zero is encountered the index is backed up to the last valid entry in the table. The value of LP is also updated.

The comparison of LR with LRM, it is noted, is analogous to the comparison of n with nmax in the general description of the invention.

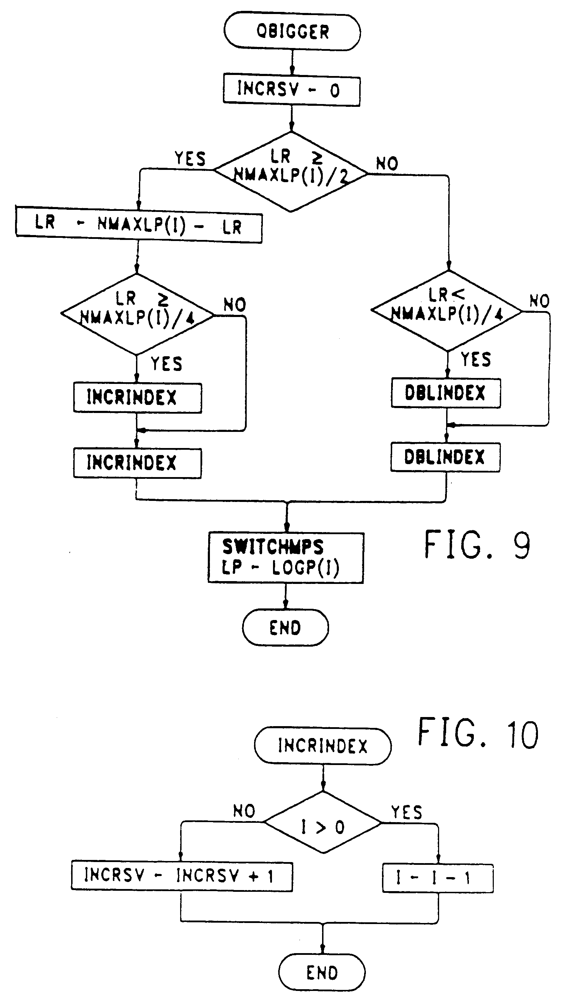

If the symbol is not an MPS, it must be an LPS. The LPS count k is then incremented and the LPS updated according to the UPDATELPS flowchart of Fig.7. UPDATELPS checks to see if probability adaptation is required by determining if kmax has been reached. If so, QBIGGER of Fig.9 is called to shift the probability table pointer to a larger Q. Then the LPS count k is zeroed and the block size LRM reset. The event counter LR is reset to zero.

If the current LPS count is within the confidence limits, the total count measure LR is checked to see if it is greater than LRM. If so, it is clamped to LRM.

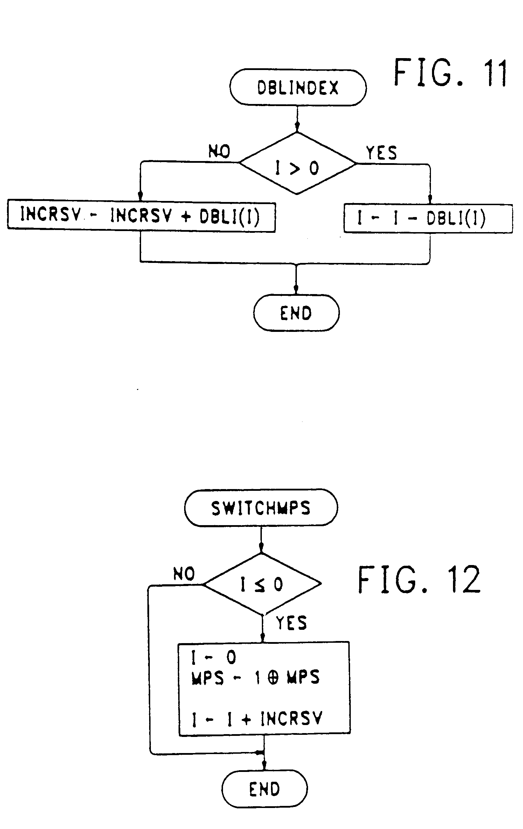

Referring to Fig.9, QBIGGER moves the probability table index to a larger Q. This action is performed by the routines INCRINDEX of Fig.10 and DBLINDEX of Fig.11. Based on the relative values of LR and NMAXPL(I), the index is moved by varying increments as is the corresponding value of Q. INCRINDEX shifts the probability table index to larger Q if possible. DBLINDEX attempts to adjust the probability table index so as to double the value of Q. In both routines, if the Q adjustment cannot be completely done, the remaining index change is saved in INCRSV for use in SWITCHMPS (in Fig.12).

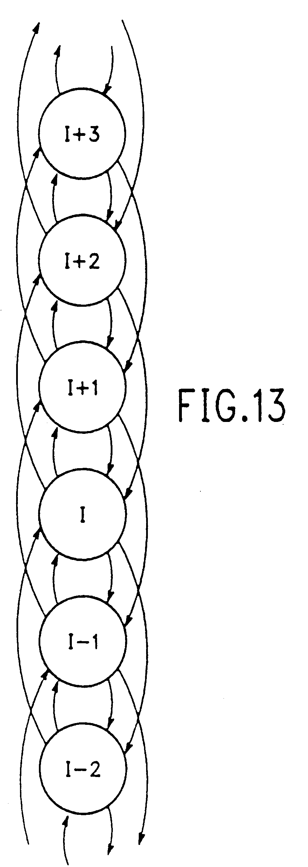

The adjustment of probabilities may be implemented as a deterministic finite state machine such as that shown in Fig.13. In Fig.13 the states of the machine are shown as (I-2), (I-1), I, (I+1), (I+2), and (I+3). For purposes of example, I is the current state (or table position) corresponding to a current probability. For purposes of discussion, suppose that the probability corresponding to the entry two positions away from state I is half or nearly half of probability of the entry at position I. Suppose that the probability for the entry at position (I+2) represents a doubling of the probability for the entry at position I. For a modest adjustment to the probability, a movement of the data pointer to an adjacent position is effectuated to either position (I-1) or (I+1) as appropriate. Thus, from state (or position) I, the machine permits the next state (or position) to be (I-2), (I-1), (I+1), or (I+2) as appropriate. This is depicted in Fig.13 by the transition arrows. By way of example, suppose that the probability at state I is 0.5 and that the probability at state (I-1) is .35 and at state (I-2) is 0.25. If k is much less than kmin, q is halved by moving the data pointer to state (I-2).

In examining Fig.13, it should be recognized that doubling and/or halving need not be confined to movement of the data pointer by two positions. For example, doubling in Fig.13 could require movement of the pointer from the current state I to position (I+3) instead of position (I+2). The transition arrow from I to (I+2) would thus be replaced by an arrow from I to (I+3). Similarly, halving could be effected by movement of the pointer any number of positions depending on the values of probabilities in the table. In any case, when the pointer moves to a new position, that new position becomes the current state from which a specified one of predefined transitions therefrom is taken depending on the existing conditions.

If required, QBIGGER also interchanges the definitions of LPS and MPS. Since the probability table does not extend beyond Q=0.5, the symbols are interchanged instead. There is thus a discontinuity in the probability adjustment procedure at Q=0.5. This discontinuity is approximately compensated for by saving the unused table index increment in INCRSV and using it (in SWITCHMPS) to adjust the index to a smaller Q after the MPS-LPS interchange. SWITCHMPS checks to see if the probability table index is at the top of the table. If so, it is time to interchange the MPS and LPS symbols. The revised definition of the MPS is stored in the state information, and any unused table adjustment is now added to I to shift the new interchanged Q to a smaller value.

The test sequence and table pointer adjustment algorithm are described in the aforementioned patent application.

Based on tests, it appears that probability adaptation by just restoring the confidence rather than tracking k/n is at least nearly optimum. Moreover, simplicity and computational savings have resulted from employing the technique of just restoring confidence. Appendix II sets forth results of tests performed with the embodiment set forth hereinabove.

## 3. Defining Allowed Probability Values

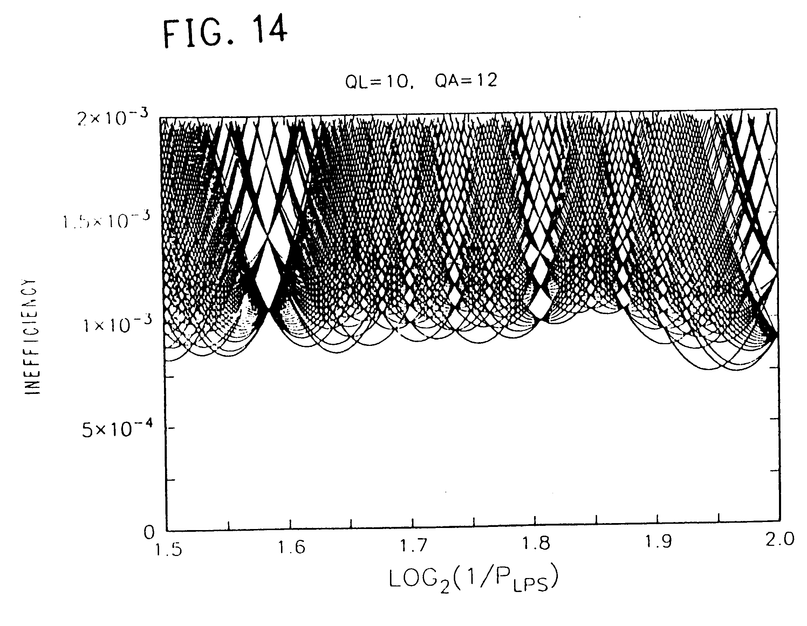

Although different techniques may be applied in defining allowed probability values, a preferred methodology is noted with reference to Fig.14. In Fig. 14, a plurality of curves are shown, each curve representing the coding inefficiency for a probability value.

It is initially noted that if probability is based on 10-bit precision, there are $2^{10}$ (or 1024) different possible probability value entries. Fig. 14 includes curves for all possible probability values for a sample probability interval.

For each possible entry, there is an Entropy defined as:

$$\text{Entropy} = P\log2(P) - Q\log2(Q)$$

where (P+Q=I). Entropy is represented in terms of bits/symbol for ideal coding. A "Bit Rate" is also defined as:

$$\text{Bit Rate} = -P\log2(P_{est}) - Q\log2(Q_{est})$$

where $(P_{est} + Q_{est}) \leq 1$. The "Bit Rate" is represented as bits per symbol for the estimated probabilities.

For a given possible probability value, there is then defined a corresponding coding inefficiency characterized as:

$$\text{INEFFICIENCY} = \frac{\text{Bit Rate} - \text{Entropy}}{\text{Entropy}}$$

QL and QA represent the log and antilog precisions, respectively. The relative error for the various probabilities is defined as the coding inefficiency as set forth hereinabove.

Fig. 14 depicts coding inefficiency along the ordinate and a probability-related value along the abscissa.

A first step in reducing the number of allowed probabilities is to retain a probability only if it has an inefficiency curve with a value at a given point along the abscissa that is less than the value of all other curves at that given point. That is, each probability that does not define a minimum relative to all other curves, at a given abscissa value, is not an allowed value.

A second step in reducing the number of allowed probabilities includes setting a maximum inefficiency value along a defined range of abscissa values. The leftmost curve -- remaining after the first step -- is followed upward and to the right of its minimum until it intersects another curve at a point above the set maximum inefficiency.

The intersection immediately preceding the intersection that exceeds the set maximum is noted, and the curve corresponding thereto is selected as the second allowed probability. (The probability for the leftmost curve is the first allowed probability.) The second allowed probability is then similarly followed until it intersects a curve above the set maximum. The preceding intersection is noted as is the curve corresponding thereto, the probability of that curve being the third allowed probability. Successive probabilities are similarly determined. In Fig. 14, the threshold is set at .002.

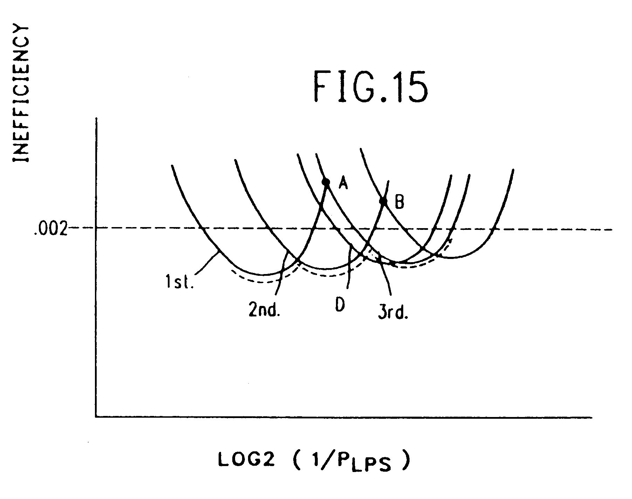

The second step is exemplified in Fig. 15. The first curve is followed to first intersection point A that exceeds the maximum inefficiency of .002. The second curve is then tracked to intersection point B. The third curve is then followed and so on. The respective probabilities corresponding to the first, second, and third curves are retained. The probability corresponding to curve D is discarded.

The last step involves retaining all curves which are retained in the first step and which are outside the range set forth in the second step. The range terminates preferably at the abscissa point beyond which no curves have inefficiencies below the maximum, e.g., .002.

The above-noted algorithm achieves tremendous reduction in the number of allowed probabilities while at the same time achieving substantial uniformity along the log probability scale. That is, for 10-bit precision, the original 1024 possible probabilities have been reduced to 48 allowed probabilities which are -- over the above-mentioned range -- substantially uniformly spaced along a log probability scale.

## 4. Alternative Embodiments

While the invention has been described with reference to preferred embodiments thereof, it will be understood by those skilled in the art that various changes in form and details may be made without departing from the scope of the invention.

For example, although a kavg of 8 has provided good results, experiments with other values ranging from 4 to 14 indicate that the choice of both kavg and the confidence limit is not critical. It is, however, important to not over-estimate the change in q, as this will lead to an excessive sensitivity to statistical fluctuations and "hunting".

Also, although each q is described as having its own $P_{k,n}$ table, these values may alternatively be computed on the fly as when a new q value is determined.

A more elegant embodiment for probability adaptation avoids dependence on the structure of the probability table. In this alternative approach, it is recognized that tables I and II contain the log2 of the ratio of the old and new q values -- a total ratio. If each entry in the table of allowed probabilities also contains a parameter dlogq (the log of the ratio of the q for this entry and the q for the entry above), the table has the following columns: log p, log q/p, nmaxlp, lgnmaxlp, and dlogq. The required new position in the corresponding table of allowed probabilities can be readily reached as follows. Subtract the dlogq for the current entry from the total ratio which yields a new total ratio. The next adjacent dlogq value (in the appropriate up or down direction) is subtracted from the new total ratio and so on until the new total ratio is zero --at which point the correct table position has been reached. Accordingly, if for example, q is to be made smaller, the process requires a very simple lookup table to obtain the required log2(q/qnew) for any given k value. Then as the pointer to the probability table is shifted to the next smaller q, dlogq is subtracted from the log of the ratio. When the log of the ratio is zero, the correct table position has been reached.

With regard to making q larger it is recognized that log2 nmax/n is a good approximation to log qnew/q. A good approximate value of log2 nmax/n can be obtained as follows: the Log Coder counts symbols in units of log2 p, where the log is scaled by a factor of 1024 to allow integer arithmetic. If the symbol count n is in units of log2 p, the value of nmax (in units of log p) does not vary more than a factor of two over the entire allowed range of p (log p from 1 to 1024). Consequently, an approximate value of log n can readily be derived from a simple lookup table, and the value of log nmax can be stored directly in the probability table itself as lgnmaxlp. The difference then provides a good estimate of log2 qnew/q. This estimate of log2 qnew/q is decremented by dlogq as the probability table pointer is moved toward larger q.

Furthermore, the algorithm for reducing the number of table entries (e.g., from 1024 to 48) may include other steps without departing from the scope of the invention as claimed. Depending on application, for example, the selection of allowed probabilities may differ.

Crossing the q = 0.5 bound requires special handling. Because the log nmax/n is an underestimation of log qnew/q after the redefinition of LPS and MPS, any remainder in log qnew/q is doubled to approximately correct for the underestimation when the crossing occurs.

Still further, the present invention contemplates as an equivalent alternative that the bounds be defined so that kmin and kmax are still within confidence. In such an embodiment, confidence is exceeded when k<kmin when nmax is exceeded, and when k>kmax. In this regard, the k<kmin condition may be examined when n = nmax or, alternatively, when n first exceeds nmax. Similarly, with regard to the $n_1$ and $n_2$ thresholds, the triggering condition may include or, alternatively, exclude the case where n = $n_1$ or where n = $n_2$, respectively. Such variations, it is readily observed, are governed by the teachings of the present invention.

The alternative embodiments provide results comparable with those achieved by the simple embodiment specified hereinabove.

Appendix I.  PDS code implementation of the probability
adaptation scheme.  Note that forward polish notation
is used so an operator is followed by its operands.

```
function adptprob yn(w);
   (called for each symbol to be encoded)
   n=+n lp                   (count the events in the confidence interval)
   if yn=mps                 (symbol = most probable symbol)
     codemps                 (sum the bits to code a mps)
     if n lge expl nmax    (if event count large enough)
       updatemps             (check n for mps update)
     endif
   else                      (symbol = least probable symbol)
     k=+k 1                  (increment lps count)
     codelps                 (sum the bits to code a lps)
     updatelps               (update q if needed)
   endif
endfn


replace tdi; 10 endrepl


register i bl p
  replace qsmaller;
    i=+i tdi                 :(next slot in probtbl)
    if logp=0                :(if end of table)
      i=-i tdi               :(back up)
    else                     :(see if q should be even smaller)
      if k->kmin1            :(really confident interval wrong)
        i=+i expl halfi      :(half of present q in table)
        if k->kmin2          :(absolutely sure interval wrong)
          i=+i expl halfi    :(halve q again)
```

```
      endif
    endif
    lp=expl logp        :(update counting unit)
  endif
endrepl


replace switchmps:
  if i lle probaddr        :(MPS change - fell off end of table)
    i=probaddr             :(force back in range)
    mps=eor mps 1          :(interchange def of MPS)
    i=+i incrsv
  endif
endrepl


replace dblindex;
  if i lgt probaddr
    i=-i expl dbli
  else
    incrsv=+incrsv expl dbli
  endif
endrepl


replace incrindex;
  if i lgt probaddr
    i=-i tdi
  else
    incrsv=+incrsv tdi
  endif
endrepl


replace qbigger;
```

```
incrsv=0
if n llt expl srl nmaxlp 1    :(if n < 1/2 nmax)
   if n llt expl srl nmaxlp 2  :(if n < 1/4 nmax)
      dblindex
   endif
   dblindex
else
   n=-expl nmaxlp n              :(amount left)
   if n lge expl srl nmaxlp 2  :(if (nmax-n) >= 1/4 nmax)
      incrindex
   endif
   incrindex                     :(next slot in probtbl)
endif
switchmps
lp=expl logp                     :(update counting unit)
endrepl


replace updatemps;
   if k -> kmin              :(if fluctuation encountered)
      qsmaller
   endif
   k=0                           :(zero lps count)
   n=0                           :(zero interval event count)
endrepl


replace updatelps;
   if k -< kmax              :(if fluctuation encountered)
      qbigger
      k=0
      n=0
   else
```

```
        if n lgt expl nmax      :(if at end of block)
          n=expl nmax                   :(clamp n - in coder, clamp difference)
        endif                          .
      endif
    endrepl


    replace codelps;
      bits=+bits expl +lqp logp
    endrepl


    replace codemps;
      bits=+bits expl logp
    endrepl
```

The following function is used to regenerate the lookup tables. Most of the code would not be required once the adaptation parameters are frozen.

```
function inittbl;
    (initiallize parameters for the adaptation test)
    float tem;
    pointer isv;
    word isvv blv;
    half nmaxdbl;
    half logpisv(base isv);
    half nmaxisv(base isv+4);
    static
      half probtbl(250);


    (initiallize probability tables)
    (* log p     log q/p     nmaxlp       halfi      dbli *)
```

init probtbl

| | | | | |
|---|---|---|---|---|
| 1024 | 0 | 16384 | hex 50 | hex 00 |
| 895 | 272 | 16110 | hex 50 | hex 0a |
| 795 | 502 | 15105 | hex 46 | hex 14 |
| 706 | 726 | 14826 | hex 46 | hex 1e |
| 628 | 941 | 14444 | hex 46 | hex 28 |
| 559 | 1150 | 13975 | hex 3c | hex 32 |
| 493 | 1371 | 13804 | hex 3c | hex 3c |
| 437 | 1578 | 13547 | hex 3c | hex 46 |
| 379 | 1819 | 13265 | hex 3c | hex 50 |
| 331 | 2044 | 13240 | hex 3c | hex 46 |
| 287 | 2278 | 12915 | hex 3c | hex 46 |
| 247 | 2521 | 12844 | hex 3c | hex 3c |
| 212 | 2765 | 12720 | hex 3c | hex 3c |
| 186 | 2971 | 12648 | hex 3c | hex 3c |
| 158 | 3227 | 12482 | hex 3c | hex 3c |
| 143 | 3382 | 12441 | hex 3c | hex 3c |
| 127 | 3566 | 12319 | hex 3c | hex 3c |
| 110 | 3788 | 12320 | hex 3c | hex 3c |
| 98 | 3965 | 12250 | hex 3c | hex 3c |
| 84 | 4200 | 12180 | hex 50 | hex 3c |
| 72 | 4435 | 12168 | hex 5a | hex 3c |
| 65 | 4590 | 12155 | hex 64 | hex 3c |
| 59 | 4737 | 12154 | hex 64 | hex 3c |
| 53 | 4899 | 12084 | hex 64 | hex 3c |
| 48 | 5050 | 12096 | hex 64 | hex 3c |
| 45 | 5147 | 12105 | hex 64 | hex 46 |
| 42 | 5250 | 12096 | hex 64 | hex 50 |
| 40 | 5325 | 12080 | hex 5a | hex 50 |
| 37 | 5441 | 12062 | hex 5a | hex 5a |
| 35 | 5527 | 12075 | hex 50 | hex 5a |

| 33 | 5617 | 12078 | hex 50 | hex 64 |
|----|------|-------|--------|--------|
| 30 | 5758 | 12060 | hex 46 | hex 64 |
| 28 | 5863 | 12068 | hex 46 | hex 64 |
| 26 | 5976 | 12090 | hex 3c | hex 64 |
| 23 | 6157 | 12075 | hex 3c | hex 64 |
| 21 | 6295 | 12075 | hex 3c | hex 64 |
| 19 | 6447 | 12103 | hex 32 | hex 5a |
| 17 | 6616 | 12121 | hex 32 | hex 50 |
| 15 | 6806 | 12150 | hex 28 | hex 46 |
| 13 | 7024 | 12181 | hex 28 | hex 3c |
| 11 | 7278 | 12221 | hex 1e | hex 3c |
| 9 | 7585 | 12294 | hex 1e | hex 32 |
| 7 | 7972 | 12411 | hex 1e | hex 28 |
| 5 | 8495 | 12615 | hex 1e | hex 1e |
| 4 | 8884 | 13120 | hex 14 | hex 1e |
| 3 | 9309 | 13113 | hex 14 | hex 1e |
| 2 | 10065 | 14574 | hex 0a | hex 14 |
| 1 | 11689 | 21860 | hex 00 | hex 0a |
| 0 | 0 | 0 | 0 | 0; |

```
kmin2=0
kmin1=1
kmin= 5
kavg= 8
kmax= 11
b1=addr probtbl
(generate nmax from logp and lqp values in table above)
begin
  if logp¬=0
    tem=*floatit expl kavg power 2 /floatit expl +lqp logp 1024.
    nmax=expl fixit floor +0.5 tem
    nmx=nmax
```

```
      km=kmax
      km=*logp km
      nmax=*logp nmax
      b1=+b1 tdi
      repeat
   endif
endbegin
b1=addr probtbl
(generate index for nmax halved (q doubled))
begin
   if logp¬=0
      isv=b1
      nmaxdbl=srl nmx 1   (nmax required is half current nmax)
      begin
         if isv llt addr probtbl
            isv=+isv tdi
            leave
         endif
         if nmaxisv < nmaxdbl
            leave
         endif
         isv=-isv tdi
         repeat
      endbegin
      dbli=expl -b1 expl isv (delta to table where q doubled)
      b1=+b1 tdi
      repeat
   endif
endbegin
b1=addr probtbl
(generate index for nmax doubled (q halved))
```

```
begin
  if logp¬=0
    isv=bl
    nmaxdbl=sll nmx 1
    begin
      if nmaxisv > nmaxdbl
        leave
      else
        isv=+isv tdi
        if logpisv=0
          isv=-isv tdi
          leave
        else
          repeat
        endif
      endif
    endbegin
    km=+kmax kmin1
    km=*logp km
    nmax=*logp nmax
    halfi=expl -isv expl bl  (delta to point where q halved)
    bl=+bl tdi
    repeat
  endif
endbegin
bl=addr probtbl
probaddr=bl
bpst=addr cbuffer
mps=1
k=0
n=0
```

20

```
    lp=expl logp
endfn


Storage definitions:


    based bl
        half logp;              (log p at index i)
        half lqp;               (log q/p, used to determine efficiency)
        half nmaxlp;            (nmax in units of log p)
        half nmax(at nmaxlp);
        half halfi;             (pointer to q halved)
        half dbli;              (pointer to q doubled)


    common
        word mps;               (most probable symbol value - 0 or 1)
        word yn;                (symbol to be coded)
        word bits;              (count bits for adaption test)
        word n;                 (event count)
        word nlp(at n);         (event count in lp units)
        word lr(at nlp);        (magnitude log of the range, same as nlp)
        half k;                 (short term lps count)
        half kmax;              (upper limit of confidence interval)
        half kavg;              (average lps count for confidence interval)
        half kmin;              (lower limit of confidence interval)
        half kmin1;             (if k ->, shift table index til nmax 2x)
        half kmin2;             (if k ->, shift table index til nmax 4x)
        half nmxsv;             (used in switchmps)
        word x;                 (finite precision window on code stream)
        word lp;                (log p)
        word lr;                (log of the range)
        word lrm;               (maximum lr before change index)



                pointer probaddr;       (address of probtbl)
                word incrsv;
```

21

Appendix II.   Test Results.

The following experiments were made using a set of 11 test files created using a random number generator. Nine of the files had fixed statistics with q probabilities from 0.5 to 0.0001. Two files had six short (1024 symbol) blocks, with varying probabilities from block to block.  One file (p6.19) changed the probability from 0.1 to 0.9 on alternate blocks; the other (p6.501) changed the probability from 0.5 to 0.01 on alternate blocks.  Note that the log2 values in the confidence limit calculation results have been multiplied by 1024.

The fixed statistics results were split into two halves (65535 symbols in each half).  In the first half the overhead for adapting from a starting probability of 0.5 is included.  The second half therefore is the true fixed statistics coding rate.  The 'ideal' coding rate is the optimum coding rate that can be achieved by the Log Coder; this is within 0.2% of the entropy limit.  Note that statistical fluctuations can sometimes produce better than 'ideal' coding rates.

Test 1:  kmin=5, kavg=8, kmax=11

See Tables I and II for confidence calculations.

Adaptation According to the Specified Embodiment

kmin2=0, kmin1=1, kmin=5, kavg=8, kmax=11

| file | 1st half | | 2nd half | | |
| --- | --- | --- | --- | --- | --- |
| | coded | ideal | coded | ideal | %inefficiency |
| p6.19 | 3168 | 2882 | | | 9.92 |

| p6.501   | 3590  | 3320  |       |       | 8.13  |
|----------|-------|-------|-------|-------|-------|
| p0.5     | 65820 | 65536 | 65832 | 65536 | 0.45  |
| p0.25    | 53591 | 53367 | 53366 | 53096 | 0.51  |
| p0.1     | 30970 | 30826 | 30795 | 30697 | 0.32  |
| p0.05    | 18792 | 18740 | 18676 | 18623 | 0.28  |
| p0.01    | 5303  | 5260  | 5180  | 5167  | 0.25  |
| p0.005   | 3166  | 3109  | 2949  | 2939  | 0.34  |
| p0.001   | 928   | 875   | 763   | 757   | 0.79  |
| p0.0005  | 510   | 464   | 448   | 452   | _0.8  |
| p0.0001  | 239   | 190   | 87    | 87    | 0.00  |

Test 2:  kmin=10, kavg=14, kmax=18

Confidence limit calculations:

For q=0.0625

confidence level=0.167177 for kmin=10., nmax=224.

| k    | qnew   | log2(q/qnew) |
|------|--------|--------------|
| 10.  | 0.0625 | 0            |
| 9.   | 0.0573 | 127          |
| 8.   | 0.0522 | 265          |
| 7.   | 0.0472 | 415          |
| 6.   | 0.0420 | 588          |
| 5.   | 0.0367 | 787          |
| 4.   | 0.0313 | 1020         |
| 3.   | 0.0259 | 1303         |
| 2.   | 0.0202 | 1665         |
| 1.   | 0.0144 | 2172         |
| 0.   | 0.0079 | 3046         |

confidence level=0.165822 for kmax=18., nmax=224.

23

| n | log2(nmax/n) | qnew | log2(qnew/q) |
|---|---|---|---|
| 18. | 3724 | 0.9050 | 5523 |
| 56. | 2047 | 0.2558 | 2081 |
| 112. | 1024 | 0.1258 | 1033 |
| 168. | 424 | 0.0835 | 427 |
| 224. | 0 | 0.0624 | _2 |

Adaptation According to the Specified Embodiment

kmin2=1, kmin1=4, kmin=10, kavg=14, kmax=18

| file | 1st half | | 2nd half | | |
|---|---|---|---|---|---|
| | coded | ideal | coded | ideal | %error |
| p6.19 | 3304 | 2832 | | | 14.64 |
| p6.501 | 3722 | 3320 | | | 12.11 |
| p0.5 | 65785 | 65536 | 65770 | 65536 | 0.36 |
| p0.25 | 53546 | 53367 | 53235 | 53096 | 0.25 |
| p0.1 | 30914 | 30826 | 30765 | 30697 | 0.22 |
| p0.05 | 18789 | 18740 | 18653 | 18623 | 0.16 |
| p0.01 | 5319 | 5260 | 5184 | 5167 | 0.33 |
| p0.005 | 3168 | 3109 | 2955 | 2939 | 0.54 |
| p0.001 | 970 | 875 | 758 | 757 | 0.13 |
| p0.0005 | 563 | 464 | 445 | 452 | _1.5 |
| p0.0001 | 276 | 190 | 87 | 87 | 0.00 |

Test 3:  kmin=2, kavg=4, kmax=6

Confidence calculations:

For q=0.0625
confidence level=0.228699 for kmin=2., nmax=64.

24

| k | qnew | log2(q/qnew) |
|---|---|---|
| 2. | 0.0625 | 0 |
| 1. | 0.0432 | 544 |
| 0. | 0.0228 | 1488 |

confidence level=0.20969 for kmax=6., nmax=64.

| n | log2(nmax/n) | qnew | log2(qnew/q) |
|---|---|---|---|
| 6. | 3496 | 0.7702 | 4219 |
| 16. | 2047 | 0.2572 | 2089 |
| 32. | 1024 | 0.1260 | 1035 |
| 48. | 424 | 0.0835 | 427 |
| 64. | 0 | 0.0624 | _3 |

Adaptation According to the Specified Embodiment

(kmin2 not used), kmin1=0, kmin=2, kavg=4, kmax=6

| file | 1st half | | 2nd half | | |
|---|---|---|---|---|---|
| | coded | ideal | coded | ideal | %error |
| p6.19 | 3052 | 2882 | | | 5.90 |
| p6.501 | 3521 | 3320 | | | 6.05 |
| p0.5 | 66038 | 65536 | 66080 | 65536 | 0.33 |
| p0.25 | 54051 | 53367 | 53752 | 53096 | 1.24 |
| p0.1 | 31115 | 30826 | 31013 | 30697 | 1.03 |
| p0.05 | 18938 | 18740 | 18817 | 18623 | 1.04 |
| p0.01 | 5322 | 5260 | 5190 | 5167 | 0.45 |
| p0.005 | 3157 | 3109 | 2974 | 2939 | 1.19 |
| p0.001 | 931 | 875 | 766 | 757 | 1.19 |
| p0.0005 | 500 | 464 | 452 | 452 | 0.00 |
| p0.0001 | 231 | 190 | 87 | 87 | 0.00 |

**Claims**

1. A computer-implemented method of adapting the probability of the occurrence of a first of two binary symbols in response to the actual occurrence of a series of binary events in an adaptive binary arithmetic coding system utilizing selected confidence limits for the probability, comprising the steps of:
counting in a first counter the number n of occurrences of events corresponding to all symbols;
counting in a second counter the number k of occurrences of the first symbol events;
producing a first test signal each time k in the second counter exceeds a prescribed maximum value kmax based on the degree of confidence;
producing a second test signal, each time n in the first counter exceeds a prescribed maximum value nmax;
testing that second counter each time n exceeds said nmax value to determine if k exceeds a selected minimum value kmin;

increasing the initially estimated LPS (least probable symbol) probability q each time k exceeds or is equal to said kmax value and zeroing said first and second counters before resuming; and

decreasing the initially estimated LPS probability q each time k is less than or equal to said kmin value when n exceeds the nmax value.

2. The method of claim 1 comprising the further steps of: evaluating a kmin as a function of the probability, a selected , maximum value for n, and a first confidence factor;

kmin representing a lower bound for the k count after the n count reaches the maximum value thereof;

evaluating a kmax as a function of the probability, the maximum value for n, and a second confidence factor;

kmax representing an upper bound for allowable values of k; and

adjusting the value of the probability, when k is less than or equal to kmax, by the minimal increment necessary to place k within the upper and lower bounds therefor.

3. The method of claim 2 wherein the step of evaluating kmin includes the step of:

representing kmax according to the expression:

$$kmax < nq + (nqp/C)^{.5}$$

and kmin by the expression:

$$kmin > nq - (nqp/C)^{.5}$$

where q is the probability for the first symbol and p is a second probability corresponding to the second symbol.

4. The method or claim 2 wherein the evaluating of kmin and kmax includes the steps of:

calculating probabilities for each of a plurality of values of k,n pairs according to the expression:

$$P_{k,n} = ( n! / k! (n-k)!) p^k q^{n-k}$$

setting the value of kmin as the highest k value at which

$$\sum_{k=0}^{kmin} P_{k,nmax} \leq \text{~~lb~~} lb$$

setting the value of kmax as the lowest value of k at which

$$\sum_{k=kmax}^{nmax} P_{k,nmax} \leq ub$$

where lb is a lower confidence level build and ub is an upper confidence level bound; and

where q is the probability for the first symbol and p is a second probability corresponding to the second symbol;

both q and p assuming new values qnew and pnew respectively pursuant to the revision step.

5. A machine-implementable method according to one of the preceding claims for adapting the probability of the least probable symbol in an adaptive binary arithmetic coding system based on symbols actually generated, the method comprising the steps of:

selecting a confidence level for the LPS probably q;

selecting a value kavg;

maintaining a total symbol count n constant;

maintaining a least probable symbol LPS count k constant;

testing the k count each time an LPS is counted, to determine if k has reached a maximum value kmax which is calculated from the kavg value, the q value, and the selected confidence level;

testing the n count each time a symbol is counted, to determine if n has exceeded or is equal to a selected maximum value nmax;

if n exceeds the nmax value, testing to determine if k exceeds a selected minimum value kmin which is calculated from the kavg value, the q value, and the selected confidence level;

increasing the initially estimated LPS probability q each time k exceeds or is equal to said kmax value and for zeroing said first and second counters before resuming, wherein said increasing step includes increasing q by the minimal increment which results in restoring confidence in the probability q;

decreasing the initially estimated LPS probability q each time k is less than or equal to said kmin value when n exceeds nmax, wherein said decreasing step includes decreasing q by the minimal increment which results in restoring confidence in the probability q; and

initializing the k and n counts and repeating the entire sequence, when n exceeds or is equal to said nmax value.

6. The method of claim 5 comprising the further step of:

maintaining the value of kmin and the value of kmax constant as q is updated to new values.

7. The method of claim 5 comprising the further steps of:

representing each q value in the logarithmic domain;

determining optimum values of q in the logarithmic domain and retaining only the optimum values;

wherein said q increasing step and said q decreasing step each includes adjusting q from one retained value to another.

8. The method of claim 7 comprising the further steps of:

maintaining kavg, kmin, and kmax constant as q changes; and

adjusting nmax according to the relationship $nmax = kavg/q$.

9. The method of claim 8 comprising the further step of:

forming respective values of $P_{k,n}$ for each retained q value wherein

$$P_{k,n} = (n! / k! (n-k)!) \, p^k \, q^{n-k}$$

based on the $P_{k,n}$ values for each q, selecting a minimal change in the value of q such that for a constant kavg, kmin, and kmax and for a corresponding nmax according to the expression $nmax = kavg/q$, the following expressions applies:

$$\sum_{k=0}^{kmin} P_{k,nmax} \leq lb$$

$$\sum_{k=kmax}^{nmax} P_{k,nmax} \leq ub$$

wherein lb is a lower bound confidence level and ub is an upper bound confidence level.

10. A method according to one of the preceeding claims for adapting the probability of a binary event comprising the steps of:

storing probabilities at respective positions in a table;

for a subject position in the table, identifiying a prescribed set of next positions from the subject position; and

adjusting to a new probability which just restores confidence from the subject position probability at which confidence was lost, which includes the step of selecting a new position from the set based on a measure of deviation between the subject position probability and actual data.

**11.** A method according to one of the preceding claims for adapting the probability of a binary event comprising the steps of:

storing only m probabilities in an n-bit precision table where m is an integer less than $2^n$ and $2^n$ is the number of possible probabilities;

for a subject position in the table, identifiying a prescribed set of next positions from the subject position and

moving a pointer from one table position to another to effectuate a change in probability.

**12.** The method of claim 11 comprising the further step of

limiting the table to include allowed probabilities, wherein each allowed estimate probability has a coding inefficiency for a given actual probability value that is a minimum relative the coding inefficiencies for all other possible probabilities at the given actual probability value.

**13.** Computer Apparatus for an adaptive binary arithmetic coding system for adjusting a symbol probability estimate working according to one of the preceding method claims 1-12 within the limits of a known degree of confidence while the coding process is being carried out, comprising:

first counter means for tracking the total symbol count n;

second counter means for tracking the least probable symbol LPS count k;

means for testing said second counter each time an LPS is counted, to determine if k has reached a selected maximum value kmax;

means for testing said first counter each time a symbol is counted, to determine if n has exceeded or is equal to a selected maximum value nmax;

means for testing said second counter each time n exceeds said nmax value to determine if k exceeds a selected minimum value kmin;

means for increasing the initially estimated LPS probability q each time k exceeds or is equal to said kmax value and for zeroing said first and second counters before resuming;

means for decreasing the initially estimated LPS probability q each time k is less than or equal to said kmin value when n exceeds the nmax value;

means for zeroing said first and second counters and repeating the entire sequence, when n exceeds said nmax value; and

means for adjusting the increases and decreases in the value of q to just restore confidence in the estimate of q.

**14.** Computer apparatus according to claim 13 which adjusts a current probability for a binary symbol based on actual data, comprising:

a deterministic finite state machine having (a) a plurality of machine states, each machine state corresponding to a probability and (b) transitions, each transition extending from one machine state to another machine state;

wherein a first machine state corresponds to the current probability and wherein said first machine state is connected to each of a prescribed set of states by a corresponding transition and wherein each state of the set corresponds to a probability differing from the probability of said first state; and

means for selecting a second machine state from the set of states when actual data indicates a corresponding deviation from the current probability.

**15.** The computer apparatus of claim 14 wherein said selecting means includes:

means for choosing a second machine state which is one position away from the position of the current probability after a confidence limit for the current probability is exceeded by no more than a corresponding predefined level.

**16.** The computer apparatus of claim 15 wherein said selecting means further includes:

means for choosing a second machine state corresponding to a position at which the current probability is doubled after a value corresponding to a first confidence limit for the current probability is exceeded

EP 0 224 753 B1

by more than a corresponding predefined level; and

means for choosing a second machine state corresponding to a position at which the current probability is halved after a value corresponding to a second confidence limit for the current probability is exceeded by more than a corresponding predefined level.

17. The computer apparatus of claim 16 wherein said selecting means further includes:

means for choosing a second machine state corresponding to a position at which the current probability is quadrupled after a value corresponding to a first confidence limit for the current probability is exceeded by more than a corresponding predefined level.

## Patentansprüche

1. Ein rechnergestütztes Verfahren zur Anpassung der Wahrscheinlichkeit des Auftretens eines ersten von zwei binären Symbolen in Reaktion auf das tatsächliche Auftreten einer Reihe von binären Ereignissen in einem adaptiven binären arithmetischen Codierungssystem, das ausgewählte Konfidenzgrenzen für die Wahrscheinlichkeit verwendet, mit den Schritten:

Zählen der Anzahl n von Vorkommnissen von Ereignissen, die allen Symbolen entsprechen, in einem ersten Zähler; Zählen der Anzahl k der Vorkommnisse der Ereignisse des ersten Symbols in einem zweiten Zähler;

Erzeugen eines ersten Testsignals jedes Mal, wenn k im zweiten Zähler einen vorgeschriebenen Maximalwert kmax, der auf dem Konfidenzgrad basiert, überschreitet;

Erzeugen eines zweiten Testsignals jedes Mal, wenn n im ersten Zähler einen vorgeschriebenen Maximalwert nmax überschreitet;

Überprüfen des zweiten Zählers jedes Mal, wenn n den Wert nmax überschreitet, um zu bestimmen, ob k einen ausgewählten Minimalwert kmin überschreitet;

Erhöhen der anfänglich abgeschätzten LPS (am wenigsten wahrscheinlichstes Symbol)-Wahrscheinlichkeit q jedes Mal, wenn k gleich dem Wert kmax ist oder diesen überschreitet und Setzen des ersten und zweiten Zählers auf null vor dem Wiederbeginn und

Verringern der anfänglich abgeschätzten LPS-Wahrscheinlichkeit q jedes Mal, wenn k kleiner als der Wert kmin oder gleich dem Wert kmin ist, wenn n den Wert nmax überschreitet.

2. Verfahren gemäß Anspruch 1, mit den weiteren Schritten:

Berechnen eines kmin als Funktion der Wahrscheinlichkeit, eines ausgewählten, maximalen Wertes für n und eines ersten Konfidenzfaktors,

wobei kmin eine untere Grenze für den k-Zählwert darstellt, nachdem der n-Zählwert seinen Maximalwert erreicht;

Berechnen eines kmax als Funktion der Wahrscheinlichkeit, des maximalen Wertes für n und eines zweiten Konfidenzfaktors,

wobei kmax eine obere Grenze für erlaubte Werte von k darstellt, und

Anpassen des Wertes der Wahrscheinlichkeit, wenn k kleiner als oder gleich kmax ist, um das minimale Inkrement, das erforderlich ist, um k zwischen seine obere und untere Grenze zu bringen.

3. Verfahren gemäß Anspruch 2, wobei der Schritt des Berechnens von kmin den Schritt einschließt:

Darstellen von kmax gemäß der Gleichung:

$$kmax < nq + (nqp/C)^{0.5}$$

und von kmin durch den Ausdruck;

$$kmin > nq - (nqp/C)^{0.5},$$

wobei q die Wahrscheinlichkeit für das erste Symbol und p eine zweite Wahrscheinlichkeit entsprechend dem zweiten Symbol ist.

4. Verfahren gemäß Anspruch 2, wobei das Berechnen von kmin und kmax die Schritte einschließt:

Berechnen von Wahrscheinlichkeiten für jeden einer Vielzahl von Werten von k,n-Paaren gemäß dem Ausdruck:

29

$P_{k,n} = (n!/ k! (n-k)!) \, p^k \, q^{n-k},$

Setzen des Wertes von kmin als höchsten k-Wert, bei dem

$$\sum_{k=0}^{kmin} P_{k,nmax} \leq uG \quad ,$$

Setzen des Wertes von kmax als den niedrigsten Wert von k, bei dem

$$\sum_{k=kmax}^{nmax} P_{k,nmax} \leq oG \quad ,$$

wobei uG eine untere Konfidenzniveaugrenze und oG eine obere Konfidenzniveaugrenze ist und
wobei q die Wahrscheinlichkeit für das erste Symbol und p eine zweite Wahrscheinlichkeit entsprechend dem zweiten Symbol ist,
wobei q und p entsprechend dem Revisionsschritt neue Werte qneu bzw. pneu annehmen.

5. Ein maschinell ausführbares Verfahren gemäß einem der vorangehenden Ansprüche zur Anpassung der Wahrscheinlichkeit des am wenigsten wahrscheinlichen Symbols in einem adaptiven binären arithmetischen Codierungssystem auf der Grundlage von tatsächlich erzeugten Symbolen, wobei das Verfahren die Schritte aufweist:
Auswählen eines Konfidenzniveaus für die LPS-Wahrscheinlichkeit q,
Auswählen eines Wertes kavg,
Konstanthalten eines Gesamt-Symbolzählwertes n,
Konstanthalten eines Zählwertes k des am wenigsten wahrscheinlichen Symbols LPS,
Überprüfen des k-Zählwertes jedesmal, wenn ein LPS gezählt wird, um zu bestimmen, ob k einen Maximalwert kmax erreicht hat, der aus dem kavg-Wert, dem q-Wert und dem ausgewählten Konfidenzniveau berechnet wird,
Überprüfen des n-Zählwertes jedesmal, wenn ein Symbol gezählt wird, um zu bestimmen, ob n einen ausgewählten Maximalwert nmax überschritten hat oder gleich diesem ist,
wenn n den Wert nmax überschreitet, Überprüfen, um zu bestimmen, ob k einen ausgewählten Minimalwert kmin überschreitet, der aus dem Wert kavg, dem q-Wert und dem ausgewählten Konfidenzniveau berechnet wird,
Erhöhen der anfänglich abgeschätzten LPS-Wahrscheinlichkeit q jedesmal, wenn k den Wert kmax überschreitet oder gleich diesem ist, und zum Setzen des ersten und zweiten Zählers auf Null vor dem Wiederbeginn, wobei der Schritt des Erhöhens das Erhöhen von q um das minimale Inkrement einschließt, das zu einer Wiederherstellung der Konfidenz bei der Wahrscheinlichkeit q führt,
Verringern der anfänglich abgeschätzten LPS-Wahrscheinlichkeit q jedesmal, wenn k kleiner als oder gleich dem Wert kmin ist, wenn n nmax überschreitet, wobei der Schritt des Verringerns das Verringern von q um das minimale Inkrement einschließt, das zu einer Wiederherstellung der Konfidenz bei der Wahrscheinlichkeit q führt, und
Initialisieren des k- und n-Zählwertes und Wiederholen der gesamten Schrittfolge, wenn n den Wert nmax überschreitet oder gleich diesem ist.

6. Verfahren gemäß Anspruch 5 mit dem weiteren Schritt:
Konstanthalten des Wertes von kmin und des Wertes von kmax, wenn q auf neue Werte aktualisiert wird.

7. Verfahren gemäß Anspruch 5 mit den weiteren Schritten:
Darstellen jedes q-Wertes in der logarithmischen Domäne,

Bestimmen optimaler Werte von q in der logarithmischen Domäne und Festhalten nur der optimalen Werte,

wobei der Schritt des Erhöhens von q und der Schritt des Verringerns von q jeweils die Anpassung von q von einem festgehaltenen Wert auf einen anderen einschließt.

8. Verfahren gemäß Anspruch 7 mit den weiteren Schritten:
Konstanthalten von kavg, kmin und kmax, wenn sich q ändert, und
Anpassen von nmax gemäß der Beziehung nmax = kavg/q.

9. Verfahren gemäß Anspruch 8 mit dem weiteren Schritt:
Bilden entsprechender Werte von $P_{k,n}$ für jeden festgehaltenen q-Wert, wobei

$$P_{k,n} = (n!/k! \, (n-k)!) \, p^k \, q^{n-k}$$

Auswahl einer minimalen Veränderung des Werts von q in Abhängigkeit der $P_{k,n}$-Werte für jedes q derart, daß für ein konstantes kavg, kmin und kmax und für ein entsprechendes nmax gemäß dem Ausdruck nmax = kavg/q die folgenden Ausdrücke gelten:

$$\sum_{k=0,}^{kmin} P_{k,nmax} \leq uG$$

$$\sum_{k=kmax}^{nmax} P_{k,nmax} \leq oG \quad ,$$

wobei uG eine untere Grenze des Konfidenzniveaus und oG eine oberes Grenze des Konfidenzniveaus ist.

10. Verfahren gemäß einem der vorangehenden Ansprüche zum Anpassen der Wahrscheinlichkeit eines binären Ereignisses mit den Schritten:
Speichern der Wahrscheinlichkeiten an entsprechenden Positionen in einer Tabelle,
Identifizieren eines vorbestimmten Satzes nächster Positionen von der aktuellen Position für eine aktuelle Position in der Tabelle, und
Anpassen an eine neue Wahrscheinlichkeit, die gerade die Konfidenz aus der Wahrscheinlichkeit der gegenwärtigen Position wiederherstellt, bei der die Konfidenz verlorengegangen ist, was den Schritt des Auswählens einer neuen Position aus dem Satz in Abhängigkeit eines Maßes der Abweichung zwischen der Wahrscheinlichkeit der gegenwärtigen Position und den tatsächlichen Daten einschließt.

11. Verfahren gemäß einem der vorangehenden Ansprüche zum Anpassen der Wahrscheinlichkeit eines binären Ereignisses mit den Schritten:
Speichern von nur m Wahrscheinlichkeiten in einer Tabelle mit n-Bit-Genauigkeit, wobei m eine ganze Zahl kleiner als $2^n$ und $2^n$ die Anzahl der möglichen Wahrscheinlichkeiten ist,
Identifizieren eines vorbestimmten Satzes nächster Positionen von der gegenwärtigen Position aus für eine aktuelle Position in der Tabelle, und
Bewegen eines Zeigers von einer Tabellenposition auf eine andere, um eine Änderung in der Wahrscheinlichkeit zu bewirken.

12. Verfahren gemäß Anspruch 11 mit dem weiteren Schritt
Begrenzen der Tabelle derart, daß sie erlaubte Wahrscheinlichkeiten enthält, wobei jede erlaubte abgeschätzte Wahrscheinlichkeit eine Codierungs-Ineffizienz für einen gegebenen tatsächlichen Wahrscheinlichkeitswert hat, die ein Minimum bezüglich der Codierungs-Ineffizienzen für alle anderen möglichen Wahrscheinlichkeiten beim gegebenen tatsächlichen Wahrscheinlichkeitswert ist.

**13.** Computergerät für ein adaptives binäres arithmetisches Codierungssystem zum Anpassen einer Abschätzung für die Symbolwahrscheinlichkeit, die während der Ausführung des Codierungsverfahrens gemäß einem der vorangehenden Verfahrensansprüche 1 bis 12 innerhalb der Grenzen eines bekannten Konfidenzgrades arbeitet, aufweisend:

erste Zählermittel zum Verfolgen des Gesamt-Symbolzählwertes n,

zweite Zählermittel zum Verfolgen des Zählwertes k des am wenigsten wahrscheinlichen Symbols LPS,

Mittel zum Überprüfen des zweiten Zählers jedesmal, wenn ein LPS gezählt wird, um zu bestimmen, ob k einen ausgewählten Maximalwert kmax erreicht hat,

Mittel zum Überprüfen des ersten Zählers jedesmal, wenn ein Symbol gezählt wird, um zu bestimmen, ob n einen ausgewählten Maximalwert nmax überschritten hat oder gleich diesem ist,

Mittel zum Überprüfen des zweiten Zählers jedesmal, wenn n den Wert nmax überschreitet, um zu bestimmen, ob k einen ausgewählten Minimalwert kmin überschreitet,

Mittel zum Erhöhen der anfänglich abgeschätzten LPS-Wahrscheinlichkeit q jedesmal, wenn k den Wert kmax überschreitet oder gleich diesem ist, und Setzen des ersten und zweiten Zählers auf Null vor dem Wiederbeginn,

Mittel zum Verringern der anfänglich abgeschätzten LPS-Wahrscheinlichkeit q jedesmal, wenn k kleiner als oder gleich dem Wert kmin ist, wenn n den Wert nmax überschreitet,

Mittel zum Setzen des ersten und zweiten Zählers auf Null und zum Wiederholen der gesamten Schrittfolge, wenn n den Wert nmax überschreitet, und

Mittel zum Anpassen der Erhöhungen und Verringerungen des Wertes von q, um gerade die Konfidenz in der Abschätzung von q wiederherzustellen.

**14.** Computergerät gemäß Anspruch 13, das eine aktuelle Wahrscheinlichkeit für ein binäres Symbol auf der Grundlage aktueller Daten anpaßt, aufweisend:

eine deterministische Finite-State-Maschine mit (a) einer Vielzahl von Maschinenzuständen, wobei jeder Maschinenzustand einer Wahrscheinlichkeit entspricht, und (b) Übergängen, wobei jeder Übergang von einem Maschinenzustand auf einen anderen Maschinenzustand erfolgt,

wobei ein erster Maschinenzustand der aktuellen Wahrscheinlichkeit entspricht und der erste Maschinenzustand mit jedem Zustand eines vorbestimmten Satzes von Zuständen durch einen entsprechenden Übergang verbunden ist und jeder Zustand des Satzes einer sich von der Wahrscheinlichkeit des ersten Zustandes unterscheidenden Wahrscheinlichkeit entspricht, und

Mittel zum Auswählen eines zweiten Maschinenzustandes aus dem Satz von Zuständen, wenn aktuelle Daten eine entsprechende Abweichung von der aktuellen Wahrscheinlichkeit anzeigen.

**15.** Computergerät gemäß Anspruch 14, wobei die Auswahlmittel einschließen:

Mittel zum Wählen eines zweiten Maschinenzustandes, der eine Position entfernt von der Position der aktuellen Wahrscheinlichkeit liegt, nachdem eine Konfidenzgrenze für die aktuelle Wahrscheinlichkeit um nicht mehr als ein entsprechendes vordefiniertes Niveau überschritten wird.

**16.** Computergerät gemäß Anspruch 15, wobei die Auswahlmittel weiter einschließen:

Mittel zum Wählen eines zweiten Maschinenzustandes entsprechend einer Position, bei der die aktuelle Wahrscheinlichkeit verdoppelt wird, nachdem ein Wert entsprechend einer ersten Konfidenzgrenze für die aktuelle Wahrscheinlichkeit um mehr als ein entsprechendes vordefiniertes Niveau überschritten ist, und

Mittel zum Wählen eines zweiten Maschinenzustandes entsprechend einer Position, bei der die aktuelle Wahrscheinlichkeit halbiert wird, nachdem ein Wert entsprechend einer zweiten Konfidenzgrenze für die aktuelle Wahrscheinlichkeit um mehr als ein entsprechendes vorbestimmtes Niveau überschritten wird.

**17.** Computergerät gemäß Anspruch 16, wobei die Auswahlmittel weiter einschließen:

Mittel zum Wählen eines zweiten Maschinenzustandes entsprechend einer Position, bei der die aktuelle Wahrscheinlichkeit vervierfacht wird, nachdem ein Wert entsprechend einer ersten Konfidenzgrenze für die aktuelle Wahrscheinlichkeit um mehr als ein entsprechendes vorbestimmtes Niveau überschritten wird.

**Revendications**

1. Procédé mis en oeuvre par ordinateur pour adapter la probabilité d'apparition d'un premier parmi deux symboles binaires en réponse à l'apparition effective d'une série d'événements binaires dans un système adaptatif binaire de codage arithmétique utilisant des limites de confiance sélectionnées pour la probabilité, comprenant des étapes consistant à :
   compter dans un premier compteur le nombre n d'apparitions d'événements correspondant à tous les symboles ;
   compter dans un second compteur le nombre k d'apparitions d'évènements correspondant au premier symbole ;
   produire un premier signal de test chaque fois que k dans le second compteur dépasse une valeur maximale prescrite kmax basée sur le degré de confiance ;
   produire un second signal de test, chaque fois que n dans le premier compteur dépasse une valeur maximale prescrite nmax ;
   tester ce second compteur chaque fois que n excède ladite valeur nmax pour déterminer si k excède une valeur minimale déterminée kmin ;
   augmenter la probabilité de SMP initialement estimée (Symbole le Moins Probable) q, chaque fois que k excède ou est égal à ladite valeur kmax et remettre à zéro lesdits premier et second compteurs avant de continuer ; et
   diminuer la probabilité q de SMP initialement estimée chaque fois que k est inférieur ou égal à ladite valeur kmin lorsque n excède la valeur nmax.

2. Procédé selon la revendication 1, comprenant les étapes additionnelles consistant à : évaluer kmin comme une fonction de la probabilité, d'une valeur maximale sélectionnée pour n, et d'un premier facteur de confiance ; kmin représentant une limite inférieur pour le comptage k après que le comptage n atteint sa valeur maximale ;
   évaluer kmax comme une fonction de la probabilité, de la valeur maximale de n, et d'un second facteur de confiance; kmax représentant une limite supérieure pour des valeurs admissibles k ; et
   ajuster la valeur de la probabilité, lorsque k est inférieur ou égal à kmax, par l'incrément minimal nécessaire pour placer k entre sa limite inférieure et sa limite supérieure.

3. Procédé selon la revendication 2, dans lequel l'étape d'évaluation de kmin comprend l'étape consistant à :
   représenter kmax selon l'expression :

   $$kmax < nq + (nqp/C)^{0,5}$$

   et kmin par l'expression :

   $$kmin > nq - (nqp/C)^{0,5}$$

   où q est la probabilité du premier symbole et p est une seconde probabilité correspondant au second symbole.

4. Procédé selon la revendication 2, dans lequel l'évaluation de kmin et de kmax comprend les étapes consistant à :
   calculer les probabilités pour chacune d'une pluralité de valeurs de paires k,n selon l'expression :

   $$P_{k,n} = (n! /k! (n-k)! \, p^k \, q^{n-k}$$

   fixer la valeur de kmin à la valeur la plus élevée de k à laquelle

   $$\sum_{k=0}^{kmin} p_{k,nmax} \leq lb$$

EP 0 224 753 B1

fixer la valeur de kmax comme étant la plus petite valeur de k à laquelle

$$\sum_{k \,=\, kmax}^{kmin} p_{k,nmax} \leq ub$$

où lb est une limite inférieure de degré de confiance et ub est une limite supérieure de degré de confiance ; et

où q est la probabilité du premier symbole et p est une seconde probabilité correspondant au second symbole ;

q et p prenant de nouvelles valeurs qnouveau et pnouveau respectivement suite à l'étape de révision.

5. Procédé exécutable par machine selon l'une des revendications précédentes pour adapter la probabilité du symbole le moins probable dans un système adaptatif binaire de codage arithmétique basé sur des symboles réellement générés, cette méthode comprenant les étapes consistant à:

sélectionner un degré de confiance pour la probabilité q de SMP ;

sélectionner une valeur k moyenne ;

maintenir constant un comptage total n de symboles ;

maintenir constant un comptage k de symboles le moins probable SMP ;

tester le comptage k chaque fois qu'un symbole SMP est compté, pour déterminer si k a atteint une valeur maximale kmax qui est calculée à partir de la valeur de kmoyen, de la valeur de q, et du degré de confiance sélectionné ;

tester le comptage de n chaque fois qu'un symbole est compté, pour déterminer si n a dépassé ou est égal a une valeur maximale sélectionnée nmax ;

si n excède la valeur nmax, tester si k dépasse une valeur minimale sélectionnée kmin qui est calculée à partir de la valeur de kmoyen, de la valeur de q, et du degré de confiance sélectionné ;

augmenter la valeur initialement estimée q du symbole de plus faible probabilité SMP chaque fois que k dépasse ou est égal à la valeur kmax et pour remettre à zéro lesdits premier et second compteurs avant de recommencer, ladite étape d'augmentation comprenant l'augmentation de q par l'incrément minimal ayant pour effet de restaurer la confiance dans la probabilité q ;

diminuer la probabilité q de SMP estimée initialement chaque fois que k est inférieur ou égal à ladite valeur kmin lorsque n excède nmax, ladite étape de diminution incluant la diminution de q par l'incrément minimal qui a pour effet de restaurer la confiance dans la probabilité q ; et

initialiser les comptages de k et n et répéter la séquence entière, lorsque n dépasse ou est égal à ladite valeur nmax.

6. Procédé selon la revendication 5, comprenant les étapes supplémentaires consistant à :

maintenir la valeur de kmin et la valeur de kmax constantes lorsque q est mis à jour par de nouvelles valeurs.

7. Procédé selon la revendication 5, comprenant les étapes supplémentaires consistant à :

représenter chaque valeur de q dans le domaine logarithmique ;

déterminer les valeurs optimales de q dans le domaine logarithmique et ne retenir que les valeurs optimales ;

où ladite étape d'augmentation de q et ladite étape de diminution de q comprennent chacune l'ajustement de q d'une valeur retenue à une autre.

8. Procédé selon la revendication 7, comprenant les étapes supplémentaires consistant à :

maintenir kmoyen, kmin, an kmax constants lorsque q change ; et

ajuster nmax en fonction de la relation nmax = kmoyen/q.

9. Procédé selon la revendication 8, comprenant l'étape supplémentaire consistant à :

former des valeurs respectives de $P_{k,n}$ pour chaque valeur de q retenue où

$$P_{k,n} = (n! \,/\, k! \,(n-k)!) \; p^k \, q^{n-k}$$

34

sur la base des $P_{k,n}$ valeurs pour chaque q, sélectionner une variation minimale de la valeur de q de telle sorte que pour kmoyen, kmin et kmax constants, et pour une valeur correspondante de nmax suivant l'expression nmax = kmoyen/q, les expressions suivantes s'appliquent :

$$\sum_{k\,=\,0}^{kmin} P_{k,nmax} \leq lb$$

$$\sum_{k\,=\,kmax}^{nmax} P_{k,nmax} \leq ub$$

où lb est une limite inférieure de confiance et ub est une limite supérieure de confiance.

10. Procédé selon l'une des revendications précédentes, pour adapter la probabilité d'un évènement binaire, comprenant les étapes consistant à :
mémoriser des probabilités à des positions respectives d'une table ;
pour une position donnée de la table, identifier un jeu prescrit de positions suivantes à partir de la position donnée ; et
ajuster à une nouvelle probabilité qui rétablit juste la confiance par rapport à la probabilité de la position donnée à laquelle la confiance a été perdue, ce qui inclut l'étape de sélection d'une nouvelle position par rapport au jeu basé sur une mesure de déviation entre la probabilité de la position donnée et des données réelles.

11. Procédé selon l'une des revendication précédentes, pour adapter la probabilité d'un événement binaire comprenant les étapes consistant à :
mémoriser seulement m probabilités dans une table de précision à n bits où m est un entier inférieur à $2^n$ et $2^n$ est le nombre de probabilités possibles ;
pour une position donnée de la table, identifier un jeu prescrit de positions suivantes à partir de la position donnée et
déplacer un pointeur d'une position de la table à une autre pour effectuer un changement de probabilité.

12. Procédé selon la revendication 11, comprenant l'étape supplémentaire consistant à
limiter la table pour inclure des probabilités permises, où chaque estimation de probabilité permise est affectée d'une inefficacité de codage par rapport à une valeur réelle de probabilité qui est minimale par rapport aux inefficacités de codage pour toutes les autres probabilités possibles pour la valeur réelle de probabilité donnée.

13. Dispositif d'ordinateur pour un système adaptatif binaire de codage arithmétique, pour ajuster une estimation de probabilité de symboles fonctionnant selon l'une des revendications de procédé précédentes 1-12, dans les limites d'un degré connu de confiance pendant que le processus de codage est mis en oeuvre, comprenant :
des premiers moyens de comptage pour surveiller le comptage du total n de symboles ;
des seconds moyens de comptage pour surveiller le comptage k de symboles les moins probables (SMP) ;
des moyens pour tester ledit second compteur chaque fois qu'un symbole le moins probable est compté, pour déterminer si k a atteint une valeur maximale sélectionnée kmax ;
des moyens pour tester ledit premier compteur chaque fois qu'un symbole est compté, pour déterminer si n a dépassé ou est égale à une valeur maximale sélectionnée nmax ;
des moyens pour tester ledit second compteur chaque fois que n dépasse la valeur de nmax pour déterminer si k dépasse une valeur kmin minimale sélectionnée ;

35

des moyens pour augmenter la probabilité initialement estimée de symbole le moins probable SMP q chaque fois que k dépasse ou est égal à ladite valeur de kmax et pour mettre à zéro lesdits premier et second compteurs avant de continuer ;

des moyens pour diminuer la probabilité q initialement estimée de symbole à moindre probabilité SMP chaque fois que k est inférieur ou égal à ladite valeur kmin lorsque n est supérieur à la valeur nmax ;

des moyens pour mettre à zéro lesdits premier et second compteurs et répéter l'intégralité de la séquence, lorsque n dépasse ladite valeur nmax ; et

des moyens pour ajuster les augmentations et les diminutions de la valeur de q pour juste rétablir la confiance dans l'estimation de q.

**14.** Dispositif d'ordinateur selon la revendication 13, ajustant une probabilité courante d'un symbole binaire en se basant sur des données réelles, comprenant :

une machine déterministe à états finis ayant (a) une pluralité d'états, chaque état correspondant à une probabilité et (b) des transitions, chaque transition s'étendant d'un état à un autre état de la machine d'états ;

dans lequel un premier état de machine correspond à la probabilité courante et dans lequel ledit premier état de machine est connecté à chacun d'un jeu prescrit d'états par une transition correspondante et/ou chaque état du jeu correspond à une probabilité différente de la probabilité dudit premier état ; et

des moyens de sélection d'un second état de machine à partir du jeu d'états lorsque des données réelles indiquent une déviation correspondante par rapport à la probabilité courante.

**15.** Dispositif d'ordinateur selon la revendication 14, dans lequel lesdits moyens de sélection comportent :

des moyens pour choisir un second état de machine qui est éloigné d'une position par rapport à la position de la probabilité courante après qu'une limite de confiance pour la probabilité courante est dépassée de moins d'un niveau correspondant prédéfini.

**16.** Dispositif d'ordinateur selon la revendication 15, dans lequel ledits moyens de sélection comprennent en outre :

des moyens pour choisir un second état de machine correspondant à une position à laquelle la probabilité courante est doublée après qu'une valeur correspondante à une première limite de confiante pour la probabilité courante est dépassée de moins d'un niveau correspondant prédéfini ; et

des moyens pour choisir un second état de machine correspondant à une position à laquelle la probabilité courante est divisée par deux après qu'une valeur correspondante à une seconde limite de confiante pour la probabilité courante est dépassée de moins d'un niveau correspondant prédéfini.

**17.** Dispositif d'ordinateur selon la revendication 16, dans lequel lesdits moyens de sélection comprennent en outre :

des moyens pour choisir un second état de machine correspondant à une position à laquelle la probabilité courante est multipliée par quatre après qu'une valeur correspondante à une première limite de confiance pour la probabilité courante est dépassée de moins d'un niveau correspondant prédéterminé.

# FIG. 1

EP 0 224 753 B1

$\underline{n}$

| | 0 | 1 | 2 | 3 | 4 | 5 | 6 | ... | 11 | 12 | ... | 127 | 128 | $(n_{max})$ |
|---|---|---|---|---|---|---|---|---|---|---|---|---|---|---|
| 0 | $P_{0,0}$ | $P_{0,1}$ | $P_{0,2}$ | $P_{0,3}$ | $P_{0,4}$ | $P_{0,5}$ | $P_{0,6}$ | | | | | | $P_{0,128}$ | |
| 1 | $\times$ | $P_{1,1}$ | $P_{1,2}$ | $P_{1,3}$ | $P_{1,4}$ | $P_{1,5}$ | $P_{1,6}$ | | | | | | $P_{1,128}$ | |
| 2 | $\times$ | $\times$ | $P_{2,2}$ | $P_{2,3}$ | $P_{2,4}$ | $P_{2,5}$ | $P_{2,6}$ | | | | | | $P_{2,128}$ | |
| 3 | $\times$ | $\times$ | $\times$ | $P_{3,3}$ | $P_{3,4}$ | $P_{3,5}$ | $P_{3,6}$ | | | | | | $P_{3,128}$ | |
| 4 | $\times$ | $\times$ | $\times$ | $\times$ | $P_{4,4}$ | $P_{4,5}$ | $P_{4,6}$ | | | | | | $P_{4,128}$ | |
| 5 | $\times$ | $\times$ | $\times$ | $\times$ | $\times$ | $P_{5,5}$ | $P_{5,6}$ | | | | | | $P_{5,128}$ | |
| 6 | $\times$ | $\times$ | $\times$ | $\times$ | $\times$ | $\times$ | $P_{6,6}$ | | | | | | | |
| 7 | $\times$ | $\times$ | $\times$ | $\times$ | $\times$ | $\times$ | $\times$ | | | | | | | |
| 8 | $\times$ | $\times$ | $\times$ | $\times$ | $\times$ | $\times$ | $\times$ | | | | | | | |
| 11 | $\times$ | $\times$ | $\times$ | $\times$ | $\times$ | $\times$ | $\times$ | | $P_{11,11}$ | $P_{11,12}$ | | $P_{11,127}$ | $P_{11,128}$ | |
| 12 | $\times$ | $\times$ | $\times$ | $\times$ | $\times$ | $\times$ | $\times$ | | $\times$ | $\times$ | | | | |
| 127 | $\times$ | $\times$ | $\times$ | $\times$ | $\times$ | $\times$ | $\times$ | | $\times$ | $\times$ | | $P_{127,127}$ | $P_{127,128}$ | |
| 128 | $\times$ | $\times$ | $\times$ | $\times$ | $\times$ | $\times$ | $\times$ | | $\times$ | $\times$ | | $\times$ | $P_{128,128}$ | |

$\underline{k}$

$(k_{avg.})$

FIG. 2

FIG. 3

EP 0 224 753 B1

FIG. 4

PROBABILITY

$q_0$  $q_{new}$  $k/n$  LPS PROBABILITY

FIG. 5

```
      ( ADPTPROB  YN )
              |
              v
      +-----------------+
      |  LR ← LR + LP   |
      +-----------------+
              |
              v
  YES      / YN = MPS \      NO
  <--------<           >-------->
           \          /            |
            \        /             v
              |              +-----------------+
              v              |   K ← K + 1     |
  NO     / LR ≥ LRM \        |   UPDATELPS     |
  <-----<            >       +-----------------+
  |      \          /              |
  |        \       /               |
  |         YES                    |
  |          |                     |
  |          v                     |
  |   +-------------+              |
  |   | UPDATEMPS   |              |
  |   +-------------+              |
  |          |                     |
  |          |                     |
  +----------+                     |
             |                     |
             v                     |
          ( END )<----------------+
```

FIG. 6

```
      ( UPDATEMPS )
           |
           v
  NO    / K ≤ KMIN \
  <----<            >
  |     \          /
  |      \        /
  |       YES
  |        |
  |        v
  |  +-------------+
  |  |  QSMALLER   |
  |  +-------------+
  |        |
  +--------+
           |
           v
  +----------------------+
  |  K ← 0               |
  |  LRM ← NMAXLP(I)     |
  |  LR ← 0              |
  +----------------------+
           |
           v
        ( END )
```

FIG. 7

```
      UPDATELPS
          │
          ▼
  NO ◄── ◄ K ≥ KMAX ► ──► YES
  │                          │
  ▼                          ▼
◄ LR ≥ LRM ►         ┌──────────────────────┐
          │          │ QBIGGER              │
          │ YES      │ K ← 0                │
          ▼          │ LRM ← NMAXLP(I)      │
  ┌──────────┐       │ LR ← 0               │
  │ LR←LRM   │       └──────────────────────┘
  └──────────┘                │
       │                      │
       └──────┬───────────────┘
              ▼
           ( END )
```

FIG. 8

```
         QSMALLER
             │
             ▼
       ┌───────────┐
       │ I ← I + 1 │
       └───────────┘
             │
             ▼
       ◄ LOGP(I) = 0 ► ──► YES
             │               │
          NO │               ▼
             ▼         ┌───────────┐
       ◄ K ≤ KMIN1 ► ─NO│ I ← I - 1 │
             │           └───────────┘
         YES │
             ▼
     ┌────────────────┐
     │ I ← I + HALFI(I)│
     └────────────────┘
             │
             ▼
       ◄ K ≤ KMIN2 ► ──NO
             │
         YES │
             ▼
     ┌────────────────┐
     │ I ← I + HALFI(I)│
     └────────────────┘
             │
             ▼
     ┌────────────────┐
     │ LP ← LOGP(I)   │
     └────────────────┘
             │
             ▼
          ( END )
```

```
                    ( QBIGGER )
                         │
                         ▼
                 ┌───────────────┐
                 │  INCRSV - 0   │
                 └───────────────┘
                         │
                         ▼
      YES        ◇ LR  ≥ ◇        NO
   ┌─────────────   NMAXLP(I)/2   ───────────────┐
   │                 ◇        ◇                   │
   ▼                                              │
┌──────────────────────┐                          │
│ LR - NMAXLP(I) - LR   │                         │
└──────────────────────┘                          │
   │                                              │
   ▼                                              ▼
◇   LR  ≥   ◇   NO              ◇   LR <   ◇   NO
◇ NMAXLP(I)/4 ◇ ─────┐         ◇ NMAXLP(I)/4 ◇ ─────┐
◇            ◇       │         ◇            ◇       │
   │ YES             │            │ YES             │
   ▼                 │            ▼                 │
┌──────────────┐     │      ┌──────────────┐        │
│  INCRINDEX   │     │      │   DBLINDEX   │        │
└──────────────┘     │      └──────────────┘        │
   │ ◄───────────────┘         │ ◄──────────────────┘
   ▼                           ▼
┌──────────────┐        ┌──────────────┐
│  INCRINDEX   │        │   DBLINDEX   │
└──────────────┘        └──────────────┘
   │                           │
   └───────────┬───────────────┘
               ▼
      ┌──────────────────┐
      │    SWITCHMPS     │       FIG. 9
      │   LP - LOGP(I)   │
      └──────────────────┘
               │
               ▼
           (  END  )
```

FIG. 9

```
                            FIG. 10
          ( INCRINDEX )
               │
               ▼
      NO  ◇         ◇  YES
   ┌──────◇  I > 0  ◇──────┐
   │      ◇         ◇      │
   ▼                       ▼
┌──────────────────┐  ┌──────────┐
│ INCRSV - INCRSV+1│  │ I - I - 1│
└──────────────────┘  └──────────┘
   │                       │
   └───────────┬───────────┘
               ▼
           (  END  )
```

FIG. 10

FIG. 11

```
        ┌─────────────┐
        │  DBLINDEX   │
        └──────┬──────┘
               │
       NO   ╱──┴──╲   YES
    ┌───────  I > 0  ───────┐
    │       ╲─────╱         │
    │                       │
┌───┴──────────────────┐ ┌──┴──────────────┐
│ INCRSV - INCRSV + DBLI(I) │ │ I - I - DBLI(I) │
└───┬──────────────────┘ └──┬──────────────┘
    │                       │
    └───────────┬───────────┘
               │
        ┌──────┴──────┐
        │     END     │
        └─────────────┘
```

FIG. 12

```
        ┌─────────────┐
        │  SWITCHMPS  │
        └──────┬──────┘
               │
       NO   ╱──┴──╲
    ┌───────  I ≤ 0
    │       ╲─────╱
    │          │ YES
    │   ┌──────┴──────────┐
    │   │ I - 0           │
    │   │ MPS - 1 ⊕ MPS   │
    │   │                 │
    │   │ I - I + INCRSV  │
    │   └──────┬──────────┘
    │          │
    └──────────┤
               │
        ┌──────┴──────┐
        │     END     │
        └─────────────┘
```

44

FIG.13

FIG. 14

QL=10, QA=12

INEFFICIENCY

$LOG_2(1/P_{LPS})$

FIG.15

INEFFICIENCY

.002

LOG2 ( 1/$P_{LPS}$ )

1st.

2nd.

3rd.

A

B

D